# EUROPEAN PATENT SPECIFICATION

(11) **EP 3 971 920 B1**
(45) Date of publication and mention of the grant of the patent: **01.04.2026**
(21) Application number: 21195029.0
(22) Date of filing: 06.09.2021
(51) Int. Cl.: H01F 1/26, H01F 41/04, H05K 1/09, H05K 1/16

(54) **RESIN COMPOSITION**
HARZZUSAMMENSETZUNG
COMPOSITION DE RÉSINE

(30) Priority: 16.09.2020 JP 2020155438
(43) Date of publication of application: 23.03.2022
(73) Proprietor: AJINOMOTO CO., INC., Chuo-ku Tokyo 104-8315 (JP)
(72) Inventor: OURA, Ichiro, Kanagawa 210-0801 (JP); OOYAMA, Hideki, Kanagawa 210-0801 (JP); TANAKA, Takayuki, Kanagawa 210-0801 (JP); HOMMA, Tatsuya, Kanagawa 210-0801 (JP)
(74) Representative: Mewburn Ellis LLP

(56) References cited:
- EP-A1- 3 771 303
- WO-A1-2019/181463
- WO-A1-2020/022393
- JP-A- 2019 067 960

## Description

### BACKGROUND OF THE INVENTION

### 1. Field of the Invention

The present invention relates to a resin composition, and a cured product, a circuit substrate, and an inductor substrate using the resin composition.

### 2. Description of the Related Art

There are sometimes the cases that a cured product that is obtained by curing a resin composition including a magnetic powder is used as a core material of an inductor part. In these cases, a Fe-Ni alloy powder had been occasionally used as the magnetic powder (Patent Literature 1).

### Related Art Reference

### Patent Literature

Patent Literature 1: Japanese Patent Application Laid-open No. 2018-178254
Patent literature 2: JP 2019 067960 A discloses a resin composition including an Fe-Ni alloy powder containing one or more elements selected from Si, A1, and Cr.
Patent literature 3: WO 2019/181463 A1 discloses a through hole filling paste, comprising an Fe-Ni alloy magnetic powder containing one or more elements selected from Si, A1, and Cr.
Patent literature 4: WO 2020/022393 A1 discloses a magnetic paste containing an Fe-Ni alloy powder including one or more elements selected from Si, A1, and Cr.

### SUMMARY OF THE INVENTION

### Problem to be Solved by the Invention

With an increase in the demand to reduce the size of electronic equipment and to make it thinner in recent years, a circuit substrate that is used in the electronic equipment is also required to have a size thereof reduced and a density of a wiring therein increased. In the circuit substrate of this type, a through hole may be formed. In addition, occasionally there are the cases that this through hole is filled with a resin composition including a magnetic powder, which is then followed by curing the resin composition to form an inductor substrate including a magnetic layer. A Fe-Ni alloy powder generally has a crystal structure thereby having a high relative magnetic permeability. Therefore, with an aim to utilize the high relative magnetic permeability possessed by the Fe-Ni alloy powder, the inventors of the present invention attempted to use the Fe-Ni alloy powder as the magnetic powder of the resin composition to fill the through hole.

When the resin composition is filled in the through hole and then cured, the cured product thereby obtained is generally polished in order to smoothen the surface of the cured product of the resin composition. However, the Fe-Ni alloy powder has a crystal structure, and thus, the hardness thereof is high and the hardness of the cured product of the resin composition including the Fe-Ni alloy powder is also high. Accordingly, the cured product of the resin composition including the Fe-Ni alloy powder is poor in the polishing workability; thus, it had been quite difficult to produce the inductor substrate.

The present invention was conceived in view of the problem described above, and thus, an object thereof is to provide: a resin composition that can produce a cured product having not only a high relative magnetic permeability but also an excellent polishing workability; a cured product of the said resin composition; and a circuit substrate and an inductor substrate that include the cured product of the said resin composition.

### Means for Solving the Problem

The inventors of the present invention carried out an extensive investigation to solve the problem described above. As a result, the inventors found that a resin composition including, as a combination, (A) a Fe-Ni alloy powder containing one or more elements selected from the group consisting of B, P, and Si and (B) an epoxy resin containing one or more nitrogen atoms in its molecular skeleton can solve the problem described above. The present invention could be accomplished on the basis of this finding.

Namely, the present invention includes the following aspects.

[1] A resin composition comprising:
   (A) a Fe-Ni alloy powder; and
   (B) an epoxy resin containing one or more nitrogen atoms in a molecular skeleton thereof, wherein
   the component (A) contains one or more elements selected from the group consisting of B, P, and Si, when a mass of the component (A) and a mass of the component (B), relative to 100% by mass of the nonvolatile components included in the resin composition, are designated by M(a) and M(b), respectively, a ratio M(b)/M(a) is 0.001 or more and 0.100 or less, and an amount of one or more elements selected from the group consisting of B and P included in the component (A) is 0.40% or more by mass and 6.00% or less by mass.
[2] The resin composition according to claim 1, wherein a total amount of Fe and Ni included in the component (A) is 94.00% or more by mass and 99.60% or less by mass.
[3] The resin composition according to [1], wherein a volume-average particle diameter of the component (A) is less than 6.0 µm.
[4] The resin composition according to [1] to [3], wherein an amount of the component (A) relative to 100% by volume of nonvolatile components included in the resin composition is 60% or more by volume and 85% or less by volume.
[5] The resin composition according to any one of [1] to [4], further comprising (C) a thermosetting resin whose viscosity at 23°C is 5 mPa·s or more and 5000 mPa·s or less.
[6] The resin composition according to [5], wherein when a mass of the component (B) and a mass of the component (C), relative to 100% by mass of the nonvolatile components included in the resin composition, are designated by M(b) and M(c), respectively, a ratio M(b)/M(c) is 0.05 or more and 2.50 or less.
[7] The resin composition according to any one of [1] to [6], further comprising (D) a curing agent.
[8] The resin composition according to any one of [1] to [7], wherein the component (A) contains 0.90% or less by mass of one or more elements selected from the group consisting of B, P, and Si.
[9] The resin composition according to any one of [1] to [8], wherein the resin composition is in a pasty form at 23°C.
[10] The resin composition according to any one of [1] to [9], wherein component (A) contains boron.
[11] The resin composition according to any one of [1] to [10], wherein component (A) contains phosphorus.
[12] Use of a resin composition according to any one of [1] to [11] to fill a hole.
[13] A cured product of the resin composition according to any one of [1] to [11].
[14] A circuit substrate comprising a cured product of the resin composition according to any one of [1] to [11] .
[15] An inductor substrate comprising the circuit substrate according to [11]. Advantageous Effects of Invention

The present invention can provide: a resin composition that can produce a cured product having not only a high relative magnetic permeability but also an excellent polishing workability; a cured product of the said resin composition; and a circuit substrate and an inductor substrate that include the cured product of the said resin composition.

### BRIEF DESCRIPTION OF THE DRAWINGS

Fig. 1 is a schematic sectional view illustrating the core substrate that is prepared in the production method of the circuit substrate relating to the first example according to one embodiment of the present invention.
Fig. 2 is a schematic sectional view illustrating the core substrate in which a through hole is formed in the production method of the circuit substrate relating to the first example according to one embodiment of the present invention.
Fig. 3 is a schematic sectional view illustrating the core substrate formed with a plated layer in the through hole in the production method of the circuit substrate relating to the first example according to one embodiment of the present invention.
Fig. 4 is a schematic sectional view illustrating the state of the resin composition filled in the through hole of the core substrate in the production method of the circuit substrate relating to the first example according to one embodiment of the present invention.
Fig. 5 is a schematic sectional view to explain the step (2) in the production method of the circuit substrate relating to the first example according to one embodiment of the present invention.
Fig. 6 is a schematic sectional view to explain the step (3) in the production method of the circuit substrate relating to the first example according to one embodiment of the present invention.
Fig. 7 is a schematic sectional view to explain the step (5) in the production method of the circuit substrate relating to the first example according to one embodiment of the present invention.
Fig. 8 is a schematic sectional view to explain the step (5) in the production method of the circuit substrate relating to the first example according to one embodiment of the present invention.
Fig. 9 is a schematic sectional view to explain the step (i) in the production method of the circuit substrate relating to the second example according to one embodiment of the present invention.
Fig. 10 is a schematic sectional view to explain the step (i) in the production method of the circuit substrate relating to the second example according to one embodiment of the present invention.
Fig. 11 is a schematic sectional view to explain the step (ii) in the production method of the circuit substrate relating to the second example according to one embodiment of the present invention.
Fig. 12 is a schematic sectional view to explain the step (iv) in the production method of the circuit substrate relating to the second example according to one embodiment of the present invention.
Fig. 13 is a schematic plane view of the circuit substrate possessed by the inductor substrate, observed from one side in the thickness direction thereof.
Fig. 14 is a schematic view illustrating a cut edge face of the circuit substrate that is cut at the place indicated by the II-II one dot chain line in Fig. 13.
Fig. 15 is a schematic plane view to explain the composition of the first conductive layer of the circuit substrate included in the inductor substrate.

### DETAILED DESCRIPTION OF THE PREFERRED EMBODIMENTS

Hereinafter, the present invention will be explained in detail in line with the preferred embodiments thereof. Here, it must be noted that the present invention is not limited to the embodiments and examples described below so that the present invention may be carried out with any arbitrary modification so far as such modification is not outside the claims or the equivalent thereof in the present invention.

In the explanation described hereinafter, " magnetic permeability" means "relative magnetic permeability" unless otherwise specifically mentioned.

### [1. Outline of the Resin Composition]

The resin composition according to one embodiment of the present invention includes (A) a Fe-Ni alloy powder and (B) an epoxy resin containing one or more nitrogen atoms in a molecular skeleton thereof. (A) The Fe-Ni alloy powder is formed of Fe-Ni alloy containing one or more elements selected from the group consisting of B, P, and Si. In the explanation hereinafter, the epoxy resin containing one or more nitrogen atoms in the molecular skeleton thereof may be called "nitrogen-containing epoxy resin" as appropriate. One or more elements selected from the group consisting of B, P, and Si may be called "additive elements" as appropriate.

The cured product that is obtained by curing the resin composition can have a high relative magnetic permeability, and is excellent in the polishing workability. In addition, the cured product usually has low magnetic loss. With regard to the mechanism how the resin composition according to this embodiment can have such excellent effects, the inventors of the present invention presume as follows.

(A) The Fe-Ni alloy powder usually has a high crystallinity because it has crystal structures formed with Fe and Ni. Since (A) the Fe-Ni alloy powder has a high crystallinity, a cured product of the resin composition including (A) the Fe-Ni alloy powder can have a high relative magnetic permeability. In addition, because (A) the Fe-Ni alloy powder includes an additive element in combination with Fe and Ni, the crystal structures of Fe and Ni are distorted. Therefore, the crystallinity of (A) the Fe-Ni alloy powder is lowered in proportion to the distortion of the crystal structure due to the additive element, so that the hardness of (A) the Fe-Ni alloy powder is lowered. Thus the hardness of the cured product including (A) the Fe-Ni alloy powder is lowered, and the polishing workability thereof can be improved. In addition, since the crystallinity of (A) the Fe-Ni alloy powder is lowered as mentioned above, the eddy current loss due to the magnetic wall in (A) the Fe-Ni alloy powder is reduced; as a result, the magnetic loss can be suppressed with keeping the high relative magnetic permeability.

Furthermore, the cured product of the resin composition including (B) the nitrogen-containing epoxy resin can usually have a hardness suitable for polishing. In addition, (B) the nitrogen-containing epoxy resin containing a nitrogen atom in the molecular skeleton thereof has a superior affinity with (A) the Fe-Ni alloy powder having the composition as described above. Therefore, the resin composition including (B) the nitrogen-containing epoxy resin can be mixed highly uniformly with (A) the Fe-Ni alloy powder. As a result, maldistribution of (A) the Fe-Ni alloy powder due to agglomeration thereof can be suppressed, the excellent advantage of (A) the Fe-Ni alloy can be utilized. Accordingly, the resin composition including (B) the nitrogen-containing epoxy resin in combination with (A) the Fe-Ni alloy powder can improve the relative magnetic permeability and polishing workability of the cured product, and can usually suppress the magnetic loss thereof.

Note that the technological scope of the present invention is not restricted by the mechanism explained hereinabove with which the advantageous effects of the present invention can be obtained, but defined by the appended claims.

The resin composition may include optional components such as (C) a thermosetting resin having a low viscosity within a particular range at 23°C and (D) a curing agent. In the explanation hereinafter, the thermosetting resin having a low viscosity within the particular range at 23°C may be called "low-viscosity thermosetting resin" as appropriate. In the explanation hereinafter, "resin component" of the resin composition means the components excluding inorganic particles such as (A) the Fe-Ni alloy powder from the nonvolatile components included in the resin composition.

### [2. (A) Fe-Ni Alloy Powder]

The resin composition according to this embodiment includes (A) the Fe-Ni alloy powder as the component (A). (A) The Fe-Ni alloy powder is the powder of the Fe-Ni alloy containing one or more additive elements selected from the group consisting of B, P, and Si. Therefore, (A) the Fe-Ni alloy powder contains a combination of Fe, Ni, and one, or two or more additive elements.

The amount of Fe included in (A) the Fe-Ni alloy powder relative to 100% by mass of (A) the Fe-Ni alloy powder is preferably 33.00% or more by mass, more preferably 38.00% or more by mass, and still more preferably 43.00% or more by mass, while especially preferably 48.00% or more by mass, and is preferably 65.00% or less by mass, more preferably 60.00% or less by mass, and still more preferably 55.00% or less by mass, while especially preferably 50.00% or less by mass. When the amount of Fe is within the above-mentioned range, the relative magnetic permeability and polishing workability of the cured product can be effectively enhanced, and in addition, the magnetic loss thereof can usually be effectively suppressed.

The amount of Ni included in (A) the Fe-Ni alloy powder relative to 100% by mass of (A) the Fe-Ni alloy powder is preferably 33.00% or more by mass, more preferably 38.00% or more by mass, and still more preferably 43.00% or more by mass, while especially preferably 48.00% or more by mass, and is preferably 65.00% or less by mass, more preferably 60.00% or less by mass, and still more preferably 55.00% or less by mass, while especially preferably 50.00% or less by mass. When the amount of Ni is within the above-mentioned range, the relative magnetic permeability and polishing workability of the cured product can be effectively enhanced, and in addition, the magnetic loss thereof can usually be effectively suppressed.

The ratio (Fe/Ni) of Fe to Ni included in (A) the Fe-Ni alloy powder is preferably 0.5 or more, and more preferably 0.7 or more, while especially preferably 0.9 or more, and is preferably 1.6 or less, and more preferably 1.4 or less, while especially preferably 1.2 or less. When the ratio (Fe/Ni) of Fe to Ni is within the above-mentioned range, the relative magnetic permeability and polishing workability of the cured product can be effectively enhanced, and in addition, the magnetic loss thereof can usually be effectively suppressed.

The total amount of Fe and Ni included in (A) the Fe-Ni alloy powder relative to 100% by mass of (A) the Fe-Ni alloy powder is preferably 85.00% or more by mass, more preferably 94.00% or more by mass, still more preferably 98.00% or more by mass, and still more preferably 99.10% or more by mass, while especially preferably 99.40% or more by mass, and is preferably 99.99% or less by mass, more preferably 99.95% or less by mass, still more preferably 99.90% or less by mass, and still more preferably 99.80% or less by mass, while especially preferably 99.60% or less by mass. When the total amount of Fe and Ni is within the above-mentioned range, the relative magnetic permeability and polishing workability of the cured product can be effectively enhanced, and in addition, the magnetic loss thereof can usually be effectively suppressed.

(A) The Fe-Ni alloy powder contains one or more additive elements selected from the group consisting of B, P, and Si. (A) The Fe-Ni alloy powder may contain only one additive element singly, or two or more of the additive elements as a combination of them. Among the additive elements, from a viewpoint to effectively suppress the magnetic loss, B and Si are preferable, while B is especially preferable.

The amount of the additive element included in (A) the Fe-Ni alloy powder relative to 100% by mass of (A) the Fe-Ni alloy powder is or more by mass, and 6.00% or less by mass, preferably 2.00% or less by mass, and preferably 0.90% or less by mass, more preferably 0.60% or less by mass. When the amount of the additive element is within the above-mentioned range, the relative magnetic permeability and polishing workability of the cured product can be effectively enhanced, and in addition, the magnetic loss thereof can usually be effectively suppressed.

(A) The Fe-Ni alloy powder may contain an optional element other than Fe, Ni, and the additive elements. Examples of the optional element may include an element originated from impurities that may be inevitably mixed thereto due to the production method of (A) the Fe-Ni alloy powder. However, from a viewpoint to effectively exhibit the advantageous effects of the present invention, it is preferable that (A) the Fe-Ni alloy powder does not include the optional element other than Fe, Ni, and the additive elements.

The amounts of Fe, Ni, and the additive element included in (A) the Fe-Ni alloy powder can be measured by using an inductively coupled plasma emission spectrophotometer (for example, "ICP-OES 720ES": manufactured by Agilent Technologies.).

(A) The Fe-Ni alloy powder usually has a high crystallinity because it has crystal structures formed by Fe and Ni. However, because (A) the Fe-Ni alloy powder includes the additive element in combination with Fe and Ni, the crystal structures of Fe and Ni are distorted. The inventors of the present invention presume that one reason of obtaining the advantageous effects of the present invention is a decrease in the crystallinity of (A) the Fe-Ni alloy powder containing the additive element as compared with an Fe-Ni alloy powder not containing the additive element, as described above.

The decrease in the crystallinity of (A) the Fe-Ni alloy powder containing the additive element as compared with the Fe-Ni alloy powder not containing the additive element can be confirmed with the X-ray diffraction spectrum. When the X-ray diffraction spectrum of the Fe-Ni alloy powder not containing the additive element is measured, a strong peak can be generally observed in the region corresponding to the plane indices (0,0,2). This peak is usually observed in the range of 2θ=50.5 to 52.0°. When the crystal structures of Fe and Ni are distorted, the width of the peak thereof (integral width) may become wider. Accordingly, when the integral width of the peak of (A) the Fe-Ni alloy powder containing the additive element is wider as compared with the Fe-Ni alloy powder not containing the additive element, distortion of the crystal structure thereof can be confirmed.

The volume-average particle diameter D50 of (A) the Fe-Ni alloy powder is preferably less than 6.0 µm, more preferably 5.5 µm or less, still more preferably 5.0 µm or less, and still more preferably 4.5 µm or less, while especially preferably 4.0 µm or less. When the volume-average particle diameter D50 of (A) the Fe-Ni alloy powder is equal to or less than the above-described upper limit value, the relative magnetic permeability and polishing workability of the cured product can be effectively enhanced. In this case, the magnetic loss can usually be effectively suppressed. (A) The Fe-Ni alloy powder having the volume-average particle diameter D50 in the above-mentioned range can be (A) the Fe-Ni alloy powder whose particle itself is small. Therefore, the cured product including (A) the Fe-Ni alloy powder having the particular volume-average particle diameter D50 can be made not to include a large particle of (A) the Fe-Ni alloy powder; thus, an excellent polishing workability can be obtained by effectively utilizing the low hardness of (A) the Fe-Ni alloy powder. In addition, because the cured product can be made not to include a large particle of (A) the Fe-Ni alloy powder as describe above, generation of a large eddy current loss due to the large particle can be suppressed, so that the magnetic loss can usually be suppressed. These actions are effective especially when the amount of (A) the Fe-Ni alloy powder is large. The lower limit of the volume-average particle diameter D50 of (A) the Fe-Ni alloy powder is preferably 1.5 µm or more, and preferably 2.0 µm or more, while more preferably 2.5 µm or more. When the volume-average particle diameter D50 of (A) the Fe-Ni alloy powder is equal to or more than the above-mentioned lower limit, this is desirable in view of the safe handling of (A) the Fe-Ni alloy powder. In addition, when the volume-average particle diameter D50 of (A) the Fe-Ni alloy powder is equal to or more than the lower limit, (A) the Fe-Ni alloy powder can be mixed highly uniformly with the resin component including (B) the nitrogen-containing epoxy resin, so that maldistribution of (A) the Fe-Ni alloy powder due to agglomeration thereof can be effectively suppressed. Accordingly, the relative magnetic permeability and polishing workability of the cured product can be effectively enhanced, and in addition, the magnetic loss thereof can usually be effectively suppressed.

The volume-average particle diameter D50 of (A) the Fe-Ni alloy powder can be measured with a laser diffraction scattering method based on the Mie scattering theory. Specifically, the particle diameter distribution thereof is prepared on the basis of volume by using a laser diffraction scattering type particle diameter distribution measurement apparatus, in which a median diameter thereof may be measured as the volume-average particle diameter D50. The alloy powders that has been dispersed in water by means of an ultrasonic wave can preferably be used as the measurement sample. Illustrative examples of the laser diffraction scattering type particle diameter distribution measurement apparatus include "LA-960" manufactured by Horiba Ltd. and "SALD-2200" manufactured by Shimadzu Corp.

The specific surface area of (A) the Fe-Ni alloy powder is preferably 3.5 m²/g or more, and more preferably 4.0 m²/g or more, while still more preferably 4.5 m²/g or more, and is preferably 15 m²/g or less, and more preferably 13 m²/g or less, while still more preferably 11 m²/g or less. When the specific surface area of (A) the Fe-Ni alloy powder is within the above-mentioned range, the relative magnetic permeability and polishing workability of the cured product can be effectively enhanced, and in addition, the magnetic loss thereof can usually be effectively suppressed. The specific surface area may be measured by the BET method.

The particles of (A) the Fe-Ni alloy powder are preferably spherical. According to the study of the inventors of the present invention, the particles of (A) the Fe-Ni alloy powder containing the additive element can usually have the surface shape with less irregularity as compared with the particles of the Fe-Ni alloy powder not containing the additive element; thus, the particles of (A) the Fe-Ni alloy powder can have the shape that is near to the spherical shape. Since (A) the Fe-Ni alloy powder can have the particle shape that is different from that of the Fe-Ni alloy powder not containing the additive element, the affinity of (A) the Fe-Ni alloy powder with the resin may be different from that of the Fe-Ni alloy powder not containing the additive element. In this embodiment, by combining the resin component such as (B) the nitrogen-containing epoxy resin with (A) the Fe-Ni alloy powder having the affinity that is different from that of the conventional Fe-Ni alloy powder not containing the additive element, the excellent effects as described above can be obtained.

The value (aspect ratio) obtained by dividing the length of the long axis with the length of the short axis of the particle of (A) the Fe-Ni alloy powder is preferably 2 or less, and more preferably 1.6 or less, while still more preferably 1.4 or less. When the aspect ratio of (A) the Fe-Ni alloy powder is within the above-mentioned range, not only the magnetic loss can be suppressed but also the viscosity of the resin composition can be lowered.

There is no restriction in the production method of (A) the Fe-Ni alloy powder. (A) The Fe-Ni alloy powder can be produced, for example, by an atomizing method. In this atomizing method, usually, while a molten material including iron, nickel, and an additive element that have been melted falls, a highly pressurized water or gas is blown to this material thereby rapidly cooling down and solidifying them to obtain (A) the Fe-Ni alloy powder. Among the atomizing methods described above, the wateratomizing method in which water is blown to the falling molten material is preferable. Examples of the atomizing method may include a method described in Japanese Patent Application Laid-open No. 2018-178254.

The amount of (A) the Fe-Ni alloy powder included in the resin composition relative to 100% by volume of the nonvolatile components included in the resin composition is preferably 60% or more by volume, and more preferably 63% or more by volume, while especially preferably 65% or more by volume, and is preferably 85% or less by volume, and more preferably 80% or less by volume, while especially preferably 75% or less by volume. When the amount of (A) the Fe-Ni alloy powder is within the above-mentioned range, the relative magnetic permeability and polishing workability of the cured product can be effectively enhanced, and in addition, the magnetic loss thereof can usually be effectively suppressed. In particular, when the amount of (A) the Fe-Ni alloy powder is equal to or more than the lower limit value in the above-mentioned range, the relative magnetic permeability of the cured product can be effectively enhanced. In addition, when the amount of (A) the Fe-Ni alloy powder is equal to or less than the upper limit value in the above-mentioned range, the magnetic loss of the cured product can be effectively suppressed, and in addition, the viscosity of the resin composition can usually be effectively lowered so as to be readily made to a pasty form.

The amount of (A) the Fe-Ni alloy powder included in the resin composition relative to 100% by mass of the nonvolatile components included in the resin composition is preferably 70% or more by mass, more preferably 80% or more by mass, still more preferably 85% or more by mass, and still more preferably 90% or more by mass, while especially preferably 92% or more by mass, and is preferably 99% or less by mass, and more preferably 98% or less by mass, while especially preferably 97% or less by mass. When the amount of (A) the Fe-Ni alloy powder is within the above-mentioned range, the relative magnetic permeability and polishing workability of the cured product can be effectively enhanced, and in addition, the magnetic loss thereof can usually be effectively suppressed. In particular, when the amount of (A) the Fe-Ni alloy powder is equal to or more than the lower limit value in the above-mentioned range, the relative magnetic permeability of the cured product can be effectively enhanced. In addition, when the amount of (A) the Fe-Ni alloy powder is equal to or less than the upper limit value in the above-mentioned range, the magnetic loss of the cured product can be effectively suppressed, and in addition, the viscosity of the resin composition can usually be effectively lowered so as to be readily made to a pasty form.

### [3. (B) Nitrogen-containing Epoxy Resin]

The resin composition according to this embodiment includes (B) the nitrogen-containing epoxy resin as the component (B). (B) The nitrogen-containing epoxy resin is the epoxy resin that contains one or more nitrogen atoms in the molecular skeleton thereof, as described before. "Epoxy resin" means a resin having an epoxy group unless otherwise specifically mentioned. When the resin composition includes (B) the nitrogen-containing epoxy resin in combination with (A) the Fe-Ni alloy powder, the relative magnetic permeability and polishing workability of the cured product can be enhanced, and in addition, the magnetic loss thereof can usually be suppressed.

The number of the nitrogen atom contained in the molecular skeleton of (B) the nitrogen-containing epoxy resin may be one, or two or more. Therefore, (B) the nitrogen-containing epoxy resin may be a compound that contains one or more nitrogen atoms and the epoxy group in the molecular skeleton thereof. Illustrative examples of (B) the nitrogen-containing epoxy resin include an amine type epoxy resin containing one, or two or more amino groups in the molecular skeleton thereof. The amino group may be any of primary, secondary, and tertiary.

It is preferable that part or the whole of (B) the nitrogen-containing epoxy resin has two or more epoxy groups in one molecule thereof. The rate of (B) the nitrogen-containing epoxy resin having two or more epoxy groups in one molecule thereof relative to 100% by mass of the nonvolatile components in (B) the nitrogen-containing epoxy resin is preferably 50% or more by mass, and more preferably 60% or more by mass, while especially preferably 70% or more by mass.

It is preferable that (B) the nitrogen-containing epoxy resin has one or more aromatic rings in one molecule thereof. Unless otherwise specifically mentioned, the aromatic ring includes: aromatic carbon rings such as a benzene ring and a naphthalene ring; and aromatic heterocyclic rings such as a pyridine ring, a pyrrole ring, a furan ring, and a thiophene ring. When two or more aromatic rings are present in the molecule thereof, these aromatic rings may be bonded with each other directly or via a connecting group such as an oxygen atom, an alkylene group, and a combination of them. Illustrative examples of the alkylene group include a methylene group, an ethylene group, a propylene group, a butylene group, a pentylene group, a hexylene group, and a 1,1-dimethylethylene group, in which the bonding sites of them are not particularly restricted.

(B) The nitrogen-containing epoxy resin may be any of an epoxy resin that is in the state of solid at 23°C (hereinafter, this is sometimes called "solid epoxy resin") and an epoxy resin that is in the state of liquid at 23°C (hereinafter, this is sometimes called "liquid epoxy resin"). A combination of the solid epoxy resin with the liquid epoxy resin may be used as (B) the nitrogen-containing epoxy resin. In particular, from a viewpoint to obtain a pasty resin composition, it is preferable to use (B) the nitrogen-containing epoxy resin that is in the state of liquid at 23°C.

From a viewpoint to effectively obtain the intended effects of the present invention, a glycidylamine type epoxy resin is preferable as (B) the nitrogen-containing epoxy resin. The glycidylamine type epoxy resin means the epoxy resin having at least one glycidylamino group and/or diglycidylamino group. Usually, the glycidylamino group has one epoxy group, and the diglycidylamino group has two epoxy groups. The glycidylamine type epoxy resin may include the glycidylamino group, or the diglycidylamino group, or a combination of the glycidylamino group and the diglycidylamino group.

The glycidylamine type epoxy resin is preferably the glycidylamine type epoxy resin that has two or more functionalities, i.e., two or more epoxy groups in one molecule thereof. The glycidylamine type epoxy resin is more preferably the glycidylamine type epoxy resin that has two or three functionalities, i.e., two or three epoxy groups in one molecule thereof. Note that the epoxy group is not limited to the epoxy group possessed by the glycidylamino group and the diglycidylamino group; the epoxy group may be those possessed by other than a glycidyloxy group.

It is preferable that the glycidylamine type epoxy resin contains an aromatic ring. At this time, it is preferable that the glycidylamino group and the diglycidylamino group in the glycidylamine type epoxy resin are bonded directly to the aromatic ring. In addition to the glycidylamino group and the diglycidylamino group, a substituent group may be further bonded to this aromatic ring. Illustrative examples of the substituent group include a monovalent epoxy-containing group and a monovalent hydrocarbon group. Illustrative examples of the monovalent epoxy-containing group include a glycidyloxy group. Illustrative examples of the monovalent hydrocarbon group include an alkyl group and an aryl group. The number of the carbon atom in the alkyl group is preferably 1 to 10, while more preferably 1 to 5. Illustrative examples of the alkyl group include a methyl group, an ethyl group, a propyl group, an isopropyl group, a butyl group, an isobutyl group, a sec-butyl group, a tert-butyl group, a pentyl group, an isopentyl group, a neopentyl group, and a 1-ethylpropyl group. The number of the carbon atom in the aryl group is preferably 6 to 14, while more preferably 6 to 10. Illustrative examples of the aryl group include a phenyl group, a 1-naphthyl group, a 2-naphthyl group, a biphenylyl group, and a 2-anthryl group.

The preferable glycidylamine type epoxy resin may be those expressed by the following formula (B-1).

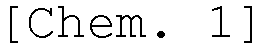

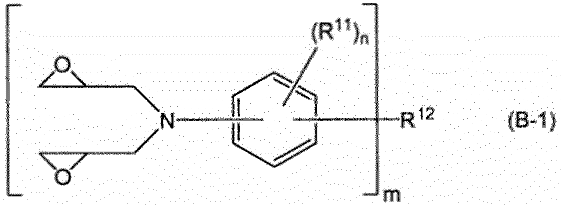

In the formula (B-1), n independently represents an integer of 0 to 4. Here, n is preferably 0 to 3, more preferably 0 to 2, and still more preferably 0 or 1, while especially preferably 1.

In the formula (B-1), m represents an integer of 1 to 3. Here, m is preferably 1 or 2, while more preferably 1.

In the formula (B-1), R¹¹ independently represents a monovalent epoxy-containing group or a monovalent hydrocarbon group. Illustrative examples of the monovalent epoxy-containing group include a glycidyloxy group. Illustrative examples of the monovalent hydrocarbon group include an alkyl group and an aryl group. The alkyl group may be linear or branched. The number of the carbon atom in the alkyl group is preferably 1 to 10, while more preferably 1 to 5. Illustrative examples of the alkyl group include a methyl group, an ethyl group, a propyl group, an isopropyl group, a butyl group, an isobutyl group, a sec-butyl group, a tert-butyl group, a pentyl group, an isopentyl group, a neopentyl group, and a 1-ethylpropyl group. The number of the carbon atom in the aryl group is preferably 6 to 14, while more preferably 6 to 10. Illustrative examples of the aryl group include a phenyl group, a 1-naphthyl group, a 2-naphthyl group, a biphenylyl group, and a 2-anthryl group.

When R¹¹ represents the glycidyloxy group, it is preferable that R¹¹ bonds at the para position with respect to the bonding site between the nitrogen atom and the benzene ring. When R¹¹ represents the alkyl group, it is preferable that R¹¹ bonds at the ortho position with respect to the bonding site between the nitrogen atom and the benzene ring.

In the formula (B-1), R¹² represents a hydrogen atom or monovalent to trivalent hydrocarbon groups. Illustrative examples of the monovalent hydrocarbon group are the same as the examples mentioned in R¹¹. Illustrative examples of the divalent hydrocarbon group include an alkylene group and an arylene group. The alkylene group may be linear or branched. The number of the carbon atom in the alkylene group is preferably 1 to 10, while more preferably 1 to 5. Illustrative examples of the alkylene group include a methylene group, an ethylene group, a propylene group, a butylene group, a pentylene group, a hexylene group, and a 1,1-dimethylethylene group. The number of the carbon atom in the arylene group is preferably 6 to 14, while more preferably 6 to 10. Illustrative examples of the arylene group include a phenylene group, a naphthylene group, and a biphenylene group.

In the formula (B-1), when m represents 1, R¹² is preferably an alkyl group, while a methyl group is more preferable. In the formula (B-1), when m represents 2, R¹² is preferably an alkylene group, while a methylene group is more preferable.

Specific Examples of the glycidylamine type epoxy resin include "630" (below formula (B-2)), "630LSD", and "604", which are all manufactured by Mitsubishi Chemical Corp.; "EP-3980S" (below formula (B-3)), "EP3950S", and "EP3950L", which are all manufactured by ADEKA Corp; and "ELM-100" (below formula (B-4)), "ELM-100H", "ELM-434" (below formula (B-5)), and "ELM-434L", which are all manufactured by Sumitomo Chemical Co., Ltd.

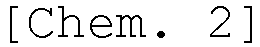

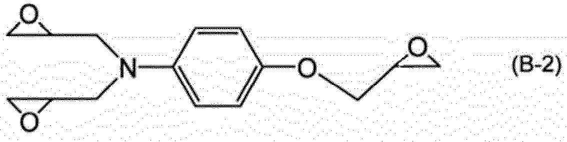

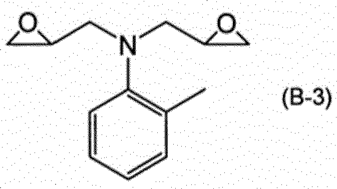

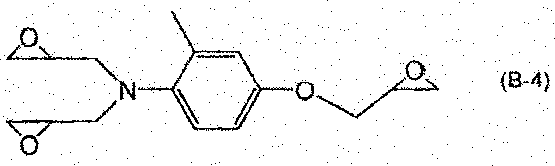

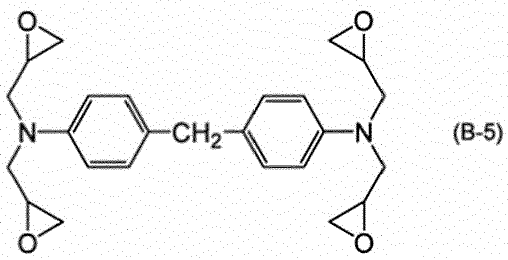

(B) The nitrogen-containing epoxy resin may be used singly or in combination of two or more kinds thereof.

The epoxy equivalent of (B) the nitrogen-containing epoxy resin is preferably 50 g/eq. to 5,000 g/eq., more preferably 60 g/eq. to 3,000 g/eq., and still more preferably 80 g/eq. to 2,000 g/eq., while especially preferably 110 g/eq. to 1,000 g/eq. When the epoxy equivalent of (B) the nitrogen-containing epoxy resin is within the above-mentioned range, the crosslinking density of the cured product of the resin composition is sufficient, so that the cured product that is excellent in the polishing workability can be obtained. The epoxy equivalent means the mass of the resin per one equivalent of the epoxy group. The epoxy equivalent can be measured by the method in accordance with JIS K7236.

The weight-average molecular weight (Mw) of (B) the nitrogen-containing epoxy resin is preferably 100 to 5,000, and more preferably 250 to 3,000, while still more preferably 400 to 1,500. The weight-average molecular weight (Mw) of the resin can be measured with a gel permeation chromatography (GPC) in terms of the polystyrene.

The amount of (B) the nitrogen-containing epoxy resin included in the resin composition relative to 100% by mass of the nonvolatile components included in the resin composition is preferably 0.1% or more by mass, more preferably 0.2% or more by mass, and still more preferably 0.4% or more by mass, while especially preferably 0.5% or more by mass, and is preferably 5.0% or less by mass, more preferably 3.0% or less by mass, and still more preferably 2.0% or less by mass, while especially preferably 1.0% or less by mass. When the amount of (B) the nitrogen-containing epoxy resin is within the above-mentioned range, the relative magnetic permeability and polishing workability of the cured product can be effectively enhanced, and in addition, the magnetic loss thereof can usually be effectively suppressed.

The amount of (B) the nitrogen-containing epoxy resin included in the resin composition relative to 100% by mass of the resin components included in the resin composition is preferably 1.0% or more by mass, more preferably 3.0% or more by mass, and still more preferably 6.0% or more by mass, while especially preferably 10% or more by mass, and preferably 80% or less by mass, more preferably 60% or less by mass, and still more preferably 30% or less by mass, while especially preferably 20% or less by mass. When the amount of (B) the nitrogen-containing epoxy resin is within the above-mentioned range, the relative magnetic permeability and polishing workability of the cured product can be effectively enhanced, and in addition, the magnetic loss thereof can usually be effectively suppressed.

When the amount of (A) the Fe-Ni alloy powder and the amount of (B) the nitrogen-containing epoxy resin relative to 100% by mass of the nonvolatile components included in the resin composition are designated by M(a) and M(b), respectively, the ratio M(b)/M(a) is preferably within a particular range. Specifically, the range of the ratio M(b)/M(a) is 0.001 or more, preferably 0.002 or more, and more preferably 0.003 or more, still more preferably 0.005 or more, and is 0.100 or less, preferably 0.050 or less, and more preferably 0.030 or less, still more preferably 0.010 or less. When the ratio M(b)/M(a) is within the above-mentioned range, the relative magnetic permeability and polishing workability of the cured product can be effectively enhanced, and in addition, the magnetic loss thereof can usually be effectively suppressed.

### [4. (C) Low-viscosity Thermosetting Resin]

It is preferable that the resin composition according to this embodiment further includes (C) a low-viscosity thermosetting resin as the component (C). (C) The low-viscosity thermosetting resin is the thermosetting resin that has a low viscosity within a particular range at 23°C. Note that (C) the low-viscosity thermosetting resin does not include (B) the nitrogen-containing epoxy resin. The resin composition that includes (C) the low-viscosity thermosetting resin can have a low viscosity under a use environment of the resin composition. Therefore, the resin composition that includes (C) the low-viscosity thermosetting resin can be a magnetic paste that is excellent in the filling property into a hole of a substrate.

The viscosity of (C) the low-viscosity thermosetting resin at 23°C is usually 5 mPa·s or more, and preferably 7 mPa·s or more, while especially preferably 10 mPa·s or more, and is usually 5,000 mPa·s or less, and preferably 4,500 mPa·s or less, while especially preferably 4,000 mPa·s or less. When (C) the low-viscosity thermosetting resin has the viscosity within the above-mentioned range, the viscosity of the resin composition can be effectively lowered so as to be readily made to a pasty form.

The viscosity of the resin can be measured by using an E-type viscometer ("RE-80U"; 3° x R9.7 rotor, manufactured by Toki Sangyo Co., Ltd.) with the sample amount of 0.22 mL, under the measurement conditions of the sample temperature at 23°C and the rotation number of 5 rpm.

(C) The low-viscosity thermosetting resin usually has a reactive group that can undergo a reaction by thermal energy. Because this reactive group can undergo a reaction, (C) the low-viscosity thermosetting resin can be thermally cured. The reactive group possessed by (C) the low-viscosity thermosetting resin may be one kind, or two or more kinds. The number of the reactive group possessed by one molecule of the (C) the low-viscosity thermosetting resin may be one, or two or more. Illustrative examples of the reactive group include an epoxy group, an acryloyl group, a methacryloyl group, and an oxetane group. Among these, from a viewpoint to effectively lower the viscosity of the resin composition, the epoxy group is preferable as the reactive group.

When (C) the low-viscosity thermosetting resin has the epoxy group, (C) the low-viscosity thermosetting resin may be classified to an epoxy resin. In this case, (C) the low-viscosity thermosetting resin is preferably the resin selected from the group consisting of a glycyrol type epoxy resin, a bisphenol A type epoxy resin, a bisphenol F type epoxy resin, a bisphenol AF type epoxy resin, a naphthalene type epoxy resin, a glycidyl ester type epoxy resin, a phenol novolak type epoxy resin, an alicyclic epoxy resin having an ester skeleton, a cyclohexane dimethanol type epoxy resin, and an epoxy resin having a butadiene structure, while the resin selected from the group consisting of a glycyrol type epoxy resin, a bisphenol A type epoxy resin, and a bisphenol F type epoxy resin is more preferable.

The reactive group equivalent of (C) the low-viscosity thermosetting resin is not particularly restricted. The reactive group equivalent of (C) the low-viscosity thermosetting resin means the mass of (C) the low-viscosity thermosetting resin per one equivalent of the reactive group. For example, when (C) the low-viscosity thermosetting resin has the epoxy group, the reactive group equivalent means the epoxy equivalent. From a viewpoint to obtain the cured product that is excellent in the polishing workability, the reactive group equivalent of (C) the low-viscosity thermosetting resin is preferably in the same range as that of the epoxy equivalent of (B) the nitrogen-containing epoxy resin.

There is no particular restriction in the weight-average molecular weight (Mw) of (C) the low-viscosity thermosetting resin. The weight-average molecular weight (Mw) of (C) the low-viscosity thermosetting resin may be in the same range as that of the weight-average molecular weight (Mw) of (B) the nitrogen-containing epoxy resin.

Commercially available products may be used as (C) the low-viscosity thermosetting resin. Specifically, illustrative examples of (C) the low-viscosity thermosetting resin include "HP4032", "HP4032D", and "HP4032SS" (naphthalene type epoxy resins), which are all manufactured by DIC Corp.; "828US" and "jER828EL" (bisphenol A type epoxy resins), "jER807" (a bisphenol F type epoxy resin), and "jER152" (a phenol novolak type epoxy resin), which are all manufactured by Mitsubishi Chemical Corp.; "EP-4088S" (a glycidyl ether type aliphatic epoxy resin) manufactured by ADEKA Corp.; "ZX1059" (a mixture of a bisphenol A type epoxy resin and a bisphenol F type epoxy resin) manufactured by Nippon Steel Chemical & Materials Co., Ltd.; "EX-721" (a glycidyl ester type epoxy resin) manufactured by Nagase ChemteX Corp.; "Celloxide 2021P" (an alicyclic epoxy resin having an ester skeleton) and "PB-3600" (an epoxy resin having a butadiene structure), which are manufactured by Daicel Corp.; and "ZX1658" and "ZX1658GS" (liquid 1,4-glycidylcyclohexane), which are manufactured by Nippon Steel Chemical & Materials Co., Ltd.

(C) The low-viscosity thermosetting resin may be used singly or in combination of two or more kinds thereof.

When the amount of (B) the nitrogen-containing epoxy resin and the amount of (C) the low-viscosity thermosetting resin relative to 100% by mass of the nonvolatile components included in the resin composition are designated by M(b) and M(c), respectively, the ratio M(b)/M(c) is preferably within a particular range. Specifically, the range of the ratio M(b)/M(c) is preferably 0.05 or more, and more preferably 0.10 or more, while especially preferably 0.15 or more, and is preferably 2.50 or less, and more preferably 2.00 or less, while especially preferably 1.70 or less. When the ratio M(b)/M(c) is within the above-mentioned range, the viscosity of the resin composition can be effectively lowered so that the pasty resin composition can be readily obtained.

The amount of (C) the low-viscosity thermosetting resin included in the resin composition relative to 100% by mass of the nonvolatile components included in the resin composition is preferably 0.1% or more by mass, more preferably 1% or more by mass, and still more preferably 2% or more by mass, while especially preferably 3% or more by mass, and is preferably 20% or less by mass, more preferably 15% or less by mass, and still more preferably 10% or less by mass, while especially preferably 5% or less by mass. When the amount of (C) the low-viscosity thermosetting resin is within the above-mentioned range, the viscosity of the resin composition can be effectively lowered so that the pasty resin composition can be readily obtained.

The amount of (C) the low-viscosity thermosetting resin included in the resin composition relative to 100% by mass of the resin components included in the resin composition is preferably 10% or more by mass, more preferably 30% or more by mass, and still more preferably 50% or more by mass, while especially preferably 70% or more by mass, and is preferably 90% or less by mass, more preferably 85% or less by mass, and still more preferably 80% or less by mass, while especially preferably 76% or less by mass. When the amount of (C) the low-viscosity thermosetting resin is within the above-mentioned range, the viscosity of the resin composition can be effectively lowered so that the pasty resin composition can be readily obtained.

When the amount of (A) the Fe-Ni alloy powder and the mass of (C) the low-viscosity thermosetting resin relative to 100% by mass of the nonvolatile components included in the resin composition are designated by M(a) and M(c), respectively, the ratio M(c)/M(a) is preferably within a particular range. Specifically, the range of the ratio M(c)/M(a) is preferably 0.01 or more, and more preferably 0.02 or more, while especially preferably 0.03 or more, and is preferably 0.50 or less, and more preferably 0.10 or less, while especially preferably 0.060 or less. When the ratio M(c)/M(a) is within the above-mentioned range, the viscosity of the resin composition can be effectively lowered so that the pasty resin composition can be readily obtained.

### [5. (D) Curing Agent]

It is preferable that the resin composition according to this embodiment further includes (D) the curing agent as the component (D). Note that (D) the curing agent does not include (B) the nitrogen-containing epoxy resin or (C) the low-viscosity thermosetting resin described before. In (D) the curing agent, there are an epoxy resin curing agent that has the function to cure the epoxy resin such as (B) the nitrogen-containing epoxy resin and a curing facilitator that has the function to facilitate the curing speed of the epoxy resin. The resin composition may include any one of the epoxy resin curing agent and the curing facilitator, or the both. In particular, it is more preferable that the resin composition include the curing facilitator as (D) the curing agent.

The epoxy resin curing agent can usually cure the resin composition by reacting with the epoxy resin. Illustrative examples of the epoxy resin curing agent include a phenol type epoxy resin curing agent, an active ester type epoxy resin curing agent, an acid anhydride type epoxy resin curing agent, a benzoxazine type epoxy resin curing agent, a cyanate ester type epoxy resin curing agent, and an amine type epoxy resin curing agent. The epoxy resin curing agent may be used singly or in combination of two or more kinds thereof.

Illustrative examples of the phenol type epoxy resin curing agent include a biphenyl type epoxy resin curing agent, a naphthalene type epoxy resin curing agent, a phenol novolak type epoxy resin curing agent, a naphthylene ether type epoxy resin curing agent, and a phenol type epoxy resin curing agent containing a triazine skeleton. In particular, the naphthalene type epoxy resin curing agent and the phenol type epoxy resin curing agent containing a triazine skeleton are more preferable.

Specifically, illustrative examples of the phenol type epoxy resin curing agent include biphenyl type epoxy resin curing agents such as "MEH-7700", "MEH-7810", and "MEH-7851" (manufactured by Meiwa Plastic Industries, Ltd.); naphthalene type epoxy resin curing agents such as "NHN", "CBN", and "GPH" (manufactured by Nippon Kayaku Co., Ltd.), as well as "SN170", "SN180", "SN190", "SN475", "SN485", "SN495", "SN375", and "SN395" (manufactured by Nippon Steel Chemical & Materials Co., Ltd.), and "EXB9500" (manufactured by DIC Corp.); phenol novolak type epoxy resin curing agents such as "TD2090" (manufactured by DIC Corp.); naphthylene ether type epoxy resin curing agents such as "EXB-6000" (manufactured by DIC Corp.); and phenol type epoxy resin curing agents containing a triazine skeleton such as "LA3018", "LA7052", "LA7054", and "LA1356" (manufactured by DIC Corp.).

There is no particular restriction in the active ester type epoxy resin curing agent. Compounds having two or more ester groups having a high reactivity in one molecule can usually preferably be used, these including phenol esters, thiophenol esters, N-hydroxylamine esters, and esters of heterocyclic hydroxy compounds. The active ester type epoxy resin curing agent is preferably the compound that is obtained by a condensation reaction of a carboxylic acid compound and/or a thiocarboxylic acid compound with a hydroxy compound and/or with a thiol compound. In particular, from a viewpoint to enhance a heat resistance, the active ester type epoxy resin curing agent obtained from a carboxylic acid compound and a hydroxy compound is preferable, while the active ester type epoxy resin curing agent obtained from a carboxylic acid compound and a phenol compound and/or a naphthol compound is more preferable. Illustrative examples of the carboxylic acid compound include benzoic acid, acetic acid, succinic acid, maleic acid, itaconic acid, phthalic acid, isophthalic acid, terephthalic acid, and pyromellitic acid. Illustrative examples of the phenol compound or the naphthol compound include hydroquinone, resorcin, bisphenol A, bisphenol F, bisphenol S, phenolphthalin, methylated bisphenol A, methylated bisphenol F, methylated bisphenol S, phenol, o-cresol, m-cresol, p-cresol, catechol, α-naphthol, β-naphthol, 1,5-dihydroxy naphthalene, 1,6-dihydroxy naphthalene, 2,6-dihydroxy naphthalene, dihydroxy benzophenone, trihydroxy benzophenone, tetrahydroxy benzophenone, phloroglucin, benzene triol, a dicyclopentadiene type diphenol compound, and phenol novolak. Here, the "dicyclopentadiene type diphenol compound" means a diphenol compound obtained by condensation of one dicyclopentadiene molecule with two phenol molecules.

Specifically, preferable are the active ester type epoxy resin curing agent containing a dicyclopentadiene type diphenol structure, the active ester type epoxy resin curing agent containing a naphthalene structure, the active ester type epoxy resin curing agent containing an acetylated phenol novolak, and the active ester type epoxy resin curing agent containing a benzoylated phenol novolak. Here, the "dicyclopentadiene type diphenol structure" means a divalent structure formed of phenylene-dicyclopentylene-phenylene.

Illustrative examples of commercially available products of the active ester type epoxy resin curing agent include: as the active ester type curing agent containing a dicyclopentadiene type diphenol structure, "EXB9451", "EXB9460", "EXB9460S", "EXB-8000L", "EXB-8000L-65M", "EXB-8000L-65TM", "HPC-8000L-65TM", "HPC-8000", "HPC-8000-65T", "HPC-8000H", and "HPC-8000H-65TM", which are all manufactured by DIC Corp.; as the active ester type curing agent containing a naphthalene structure, "EXB-8100L-65T", "EXB-8150-60T", "EXB-8150-62T", "EXB-9416-70BK", "HPC-8150-60T", and "HPC-8150-62T", which are all manufactured by DIC Corp.; as the active ester type curing agent containing phosphorous, "EXB9401" manufactured by DIC Corp.; as the active ester type curing agent containing an acetylated phenol novolak, "DC808" manufactured by Mitsubishi Chemical Corp.; as the active ester type curing agent containing a benzoylated phenol novolak, "YLH1026", "YLH1030", and "YLH1048", which are all manufactured by Mitsubishi Chemical Corp.; and as the active ester type curing agent containing a styryl group and a naphthalene structure, "PC1300-02-65MA" manufactured by Air Water Inc.

The acid anhydride type epoxy resin curing agent may be the epoxy resin curing agent having one or more acid anhydride groups in one molecule thereof. Specifically, illustrative examples of the acid anhydride type epoxy resin curing agent include phthalic anhydride, tetrahydrophthalic anhydride, hexahydrophthalic anhydride, methyltetrahydrophthalic anhydride, methylhexahydrophthalic anhydride, methylnadic anhydride, hydrogenated methylnadic anhydride, trialkyltetrahydrophthalic anhydride, dodecenylsuccinic anhydride, 5-(2,5-dioxotetrahydro-3-furanyl)-3-methyl-3-cyclohexene-1,2-dicarboxylic anhydride, trimellitic anhydride, pyromellitic anhydride, benzophenone tetracarboxylic dianhydride, biphenyl tetracarboxylic dianhydride, naphthalene tetracarboxylic dianhydride, oxydiphthalic dianhydride, 3,3'-4,4'-diphenylsulfone tetracarboxylic dianhydride, 1,3,3a,4,5,9b-hexahydro-5-(tetrahydro-2,5-dioxo-3-furanyl)-naphtho[1,2-C]furan-1,3-dione, ethyleneglycol bis(anhydrotrimellitate), and a polymer type acid anhydride such as a styrene-maleic acid resin, which is a copolymer of styrene and maleic acid. Illustrative examples of commercially available products of the acid anhydride type epoxy resin curing agent include: "HNA-100" and "MH-700", which are manufactured by New Japan Chemical Co., Ltd.

Specifically, illustrative examples of the benzoxazine type epoxy resin curing agent include "JBZ-OP100D" and "ODA-BOZ", which are manufactured by JFE Chemical Corp.; "HFB2006M" manufactured by Showa Highpolymer Co., Ltd.; and "P-d" and "F-a", which are manufactured by Shikoku Chemicals Corp.

Illustrative examples of the cyanate ester type epoxy resin curing agent include bifunctional cyanate resins such as bisphenol A dicyanate, polyphenol cyanate, oligo(3-methylene-1,5-phenylenecyanate), 4,4'-methylenebis(2,6-dimethylphenylcyanate), 4,4'-ethylidene diphenyl dicyanate, hexafluorobisphenol A dicyanate, 2,2-bis(4-cyanate)phenylpropane, 1,1-bis(4-cyanatephenylmethane), bis(4-cyanate-3,5-dimethylphenyl)methane, 1,3-bis(4-cyanatephenyl-1-(methylethylidene))benzene, bis(4-cyanatephenyl) thioether, and bis(4-cyanatephenyl) ether, polyfunctional cyanate resins derived from a phenol novolak, a cresol novolak, and the like, and a prepolymer in which these cyanate resins are partially made to triazine. Specific examples of the cyanate ester type epoxy resin curing agent include "PT30" and "PT60" (both are phenol novolak type polyfunctional cyanate ester resins); "BA230" and "BA230S75" (prepolymers in which part or all of bisphenol A dicyanate is made to triazine so as to be a trimer), all of these being manufactured by Lonza Japan Ltd.

The amine type epoxy resin curing agent may be the epoxy resin curing agent having an amino group that has one or more active hydrogens in one molecule thereof. Specifically, illustrative examples of the amine type epoxy resin curing agent include diethylenetriamine, triethylenetetramine, diaminodiphenyl sulfone, and dicyandiamide. Illustrative examples of commercially available products of the amine type epoxy resin curing agent include "DICY7" manufactured by Mitsubishi Chemical Corp.

The quantity ratio of the epoxy resin to the epoxy resin curing agent in terms of the ratio of [total number of the epoxy groups in the epoxy resins] : [total number of the reactive groups in the epoxy resin curing agents] is preferably in the range of 1:0.2 to 1:2, and more preferably in the range of 1:0.3 to 1:1.5, while still more preferably in the range of 1:0.4 to 1:1. Note that the reactive group of the epoxy resin curing agent means an active hydroxy group, an active ester group, and the like, and these are different depending on the kind of the epoxy resin curing agent. The total number of the epoxy groups in the epoxy resin means the total value of the values obtained by dividing the mass of the nonvolatile components in each of the epoxy resins with the epoxy equivalent, and by adding the divided values for all the epoxy resins. The total number of the reactive groups in the epoxy resin curing agent means the total value of the values obtained by dividing the mass of the nonvolatile components in each of the epoxy resin curing agents with the reactive group equivalent, and by adding the divided values for all the epoxy resin curing agents. When the quantity ratio of the epoxy resin to the epoxy resin curing agent is within this range, the heat resistance of the cured product thereby obtained can be enhanced furthermore.

The curing facilitator usually acts as the catalyst of the curing reaction of the epoxy resin so that the curing reaction can be facilitated. Illustrative examples of the curing facilitator include an amine type curing facilitator, an imidazole type curing facilitator, a phosphorous type curing facilitator, a guanidine type curing facilitator, a urea type curing facilitator, and a metal type curing facilitator. From a viewpoint to lower the viscosity of the resin composition, the curing facilitator is preferably the amine type curing facilitator, the imidazole type curing facilitator, and the guanidine type curing facilitator; furthermore, from a viewpoint to enhance the mechanical strength of the cured product, the imidazole type curing facilitator is more preferable. The curing facilitator may be used singly or in combination of two or more kind thereof.

Illustrative examples of the amine type curing facilitator include: trialkylamines such as triethylamine and tributylamine; and 4-dimethylaminopyridine, benzyl dimethyl amine, 2,4,6-tris(dimethylaminomethyl)phenol, and 1,8-diazabicyclo(5,4,0)-undecene. Among these, 4-dimethylaminopyridine and 1,8-diazabicyclo(5,4,0)-undecene are preferable. Commercially available products may be used as the amine type curing facilitator. Illustrative examples thereof include "PN-50", "PN-23", and "MY-25", which are all manufactured by Ajinomoto Fine-Techno Co., Ltd.

Illustrative examples of the imidazole type curing facilitator include imidazole compounds such as 2-methylimidazole, 2-undecylimidazole, 2-heptadecylimidazole, 1,2-dimethylimidazole, 2-ethyl-4-methylimidazole, 1,2-dimethylimidazole, 2-ethyl-4-methylimidazole, 2-phenylimidazole, 2-phenyl-4-methylimidazole, 1-bezyl-2-methylimidazole, 1-benzyl-2-phenylimidazole, 1-cyanoethyl-2-methylimidazole, 1-cyanoethyl-2-undecylimidazole, 1-cyanoethyl-2-ethyl-4-methylimidazole, 1-cyanoethyl-2-phenylimidazole, 1-cyanoethyl-2-undecylimidazolium trimellitate, 1-cyanoethyl-2-phenylimidazolium trimellitate, 2,4-diamino-6-[2'-methylimidazolyl-(1')]-ethyl-s-triazine, 2,4-diamino-6-[2'-undecylimidazolyl-(1')]-ethyl-s-triazine, 2,4-diamino-6-[2'-ethyl-4'-metylimidazolyl-(1')]-ethyl-s-triazine, a 2,4-diamino-6-[2'-methylimidazolyl-(1')]-ethyls-triazine isocyanuric acid adduct, a 2-phenylimidazole isocyanuric acid adduct, 2-phenyl-4,5-dihydroxymethylimidazole, 2-phenyl-4-methyl-5-hydroxymethylimidazole, 2,3-dihydro-1H-pyrro[1,2-a]benzimidazole, 1-dodecyl-2-methyl-3-benzylimidazolium chloride, 2-methylimidazoline, and a 2-phenylimidazoline; and adducts of these imidazole compounds with an epoxy resin. Among these, 2-ethyl-4-methylimidazole and 1-benzyl-2-phenylimidazole are preferable. Commercially available products may be used as the imidazole type curing facilitator. Illustrative examples thereof include "2MZA-PW" and "2PHZ-PW", which are manufactured by Shikoku Chemicals Corp., and "P200-H50" manufactured by Mitsubishi Chemical Corp.

Illustrative examples of the phosphorous type curing facilitator include triphenyl phosphine, a phosphonium borate compound, tetraphenyl phosphonium tetraphenyl borate, n-butyl phosphonium tetraphenyl borate, a tetrabutyl phosphonium decanoate salt, (4-methylphenyl) triphenyl phosphonium thiocyanate, tetraphenyl phosphonium thiocyanate, and butyl triphenyl phosphonium thiocyanate. Among these, triphenyl phosphine and a tetrabutyl phosphonium decanoate salt are preferable.

Illustrative examples of the guanidine type curing facilitator include dicyandiamide, 1-methyl guanidine, 1-ethyl guanidine, 1-cyclohexyl guanidine, 1-phenyl guanidine, 1-(o-tolyl) guanidine, dimethyl guanidine, diphenyl guanidine, trimethyl guanidine, tetramethyl guanidine, pentamethyl guanidine, 1,5,7-triazabicyclo[4.4.0]deca-5-ene, 7-methyl-1,5,7-triazabicyclo[4.4.0]deca-5-ene, 1-methyl biguanide, 1-ethyl biguanide, 1-n-butyl biguanide, 1-n-octadecyl biguanide, 1,1-dimethyl biguanide, 1,1-diethyl biguanide, 1-cyclohexyl biguanide, 1-allyl biguanide, 1-phenyl biguanide, and 1-(o-tolyl) biguanide. Among these, dicyandiamide and 1,5,7-triazabicyclo[4.4.0]deca-5-ene are preferable.

Illustrative examples of the urea type curing facilitator include 1,1-dimethylurea; aliphatic dimethylureas such as 1,1,3-trimethylurea, 3-ethyl-1,1-dimethylurea, 3-cyclohexyl-1,1-dimethylurea, and 3-cyclooctyl-1,1-dimethylurea; and aromatic dimethylureas such as 3-phenyl-1,1-dimethylurea, 3-(4-chlorophenyl)-1,1-dimethylurea, 3-(3,4-dichlorophenyl)-1,1-dimethylurea, 3-(3-chloro-4-methylphenyl)-1,1-dimethylurea, 3-(2-methylphenyl)-1,1-dimethylurea, 3-(4-methylphenyl)-1,1-dimethylurea, 3-(3,4-dimethylphenyl)-1,1-dimethylurea, 3-(4-isopropylphenyl)-1,1-dimethylurea, 3-(4-methoxyphenyl)-1,1-dimethylurea, 3-(4-nitrophenyl)-1,1-dimethylurea, 3-[4-(4-methoxyphenoxy)phenyl]-1,1-dimethylurea, 3-[4-(4-chlorophenoxy)phenyl]-1,1-dimethylurea, 3-[3-(trifluoromethyl)phenyl]-1,1-dimethylurea, N,N-(1,4-phenylene) bis(N',N'-dimethylurea), and N,N-(4-methyl-1,3-phenylene) bis(N',N'-dimethylurea) [toluene bisdimethylurea].

Illustrative examples of the metal type curing facilitator include organometallic complexes or organometallic salts of metals such as cobalt, copper, zinc, iron, nickel, manganese, and tin. Specific examples of the organometallic complex include organic cobalt complexes such as cobalt (II) acetylacetonate and cobalt (III) acetylacetonate; organic copper complexes such as copper (II) acetylacetonate; organic zinc complexes such as zinc (II) acetylacetonate; organic iron complexes such as iron (III) acetylacetonate; organic nickel complexes such as nickel (II) acetylacetonate; and organic manganese complexes such as manganese (II) acetylacetonate. Illustrative examples of the organometallic salt include zinc octylate, tin octylate, zinc naphthenate, cobalt naphthenate, tin stearate, and zinc stearate.

The amount of (D) the curing agent included in the resin composition relative to 100% by mass of the nonvolatile components in the resin composition is preferably 0.1% or more by mass, and more preferably 0.3% or more by mass, while still more preferably 0.5% or more by mass, and is preferably 5% or less by mass, and more preferably 3% or less by mass, while still more preferably 2% or less by mass. When the amount of (D) the curing agent is within the above-mentioned range, not only the viscosity of the resin composition can be lowered but also the pot life of the viscosity can be prolonged.

The amount of (D) the curing agent included in the resin composition relative to 100% by mass of the resin components in the resin composition is preferably 1% or more by mass, and more preferably 5% or more by mass, while still more preferably 10% or more by mass, and is preferably 50% or less by mass, and more preferably 30% or less by mass, while still more preferably 20% or less by mass. When the amount of (D) the curing agent is within the above-mentioned range, not only the viscosity of the resin composition can be lowered but also the pot life of the viscosity can be prolonged.

When the amount of (B) the nitrogen-containing epoxy resin, the amount of (C) the low-viscosity thermosetting resin, and the amount of (D) the curing agent, relative to 100% by mass of the nonvolatile components included in the resin composition, are designated by M(b), M(c), and M(d), respectively, the ratio {M(b)+M(c)}/M(d) is preferably within a particular range. Specifically, the range of the ratio {M(b)+M(c)}/M(d) is preferably 1 or more, and more preferably 2 or more, while especially preferably 4 or more, and is preferably 15 or less, and more preferably 12 or less, while especially preferably 10 or less. When the ratio {M(b)+M(c)}/M(d) is within the above-mentioned range, the viscosity of the resin composition can be effectively lowered so that the pasty resin composition can be readily obtained.

### [6. Optional Component]

The resin composition according to this embodiment may further include an optional nonvolatile component in combination with the components described above. Illustrative examples of the optional nonvolatile component include: inorganic particles other than (A) the Fe-Ni alloy powder; radical-polymerizable compounds such as a maleimide type radical-polymerizable compound, a vinylphenyl type radical-polymerizable compound, a (meth)acrylic type radical-polymerizable compound, an allyl type radical-polymerizable compound, and a polybutadiene type radical-polymerizable compound; radical polymerization initiators such as a peroxide type radical polymerization initiator and an azo type radical polymerization initiator; thermoplastic resins such as a polyvinylacetal resin, a polyolefin resin, a polysulfone resin, a polyether sulfone resin, a polyphenylene ether resin, a polycarbonate resin, a polyether ether ketone resin, and a polyester resin; organic fillers such as rubber particles; organic metal compounds such as an organic copper compound and an organic zinc compound; polymerization inhibitors such as hydroquinone, catechol, pyrogallol, and phenothiazine; leveling agents such as a silicone type leveling agent and an acrylic polymer type leveling agent; thickeners such as bentone and montmorillonite; antifoaming agents such as a silicone type antifoaming agent, an acrylic type antifoaming agent, a fluorine type antifoaming agent, and a vinyl resin type antifoaming agent; UV absorbers such as a benzotriazole type UV absorber; adhesion enhancers such as a urea silane; adhesion assisting agents such as a triazole type adhesion assisting agent, a tetrazole type adhesion assisting agent, and a triazine type adhesion assisting agent; antioxidants such as a hindered phenol type antioxidant and a hindered amine type antioxidant; fluorescent whitening agents such as a stilbene derivative; surfactants such as a fluorine type surfactant and a silicone type surfactant; flame retardants such as phosphorous type flame retardants (for example, phosphate ester compounds, phosphazene compounds, phosphinate compounds, and red phosphorous), nitrogen type flame retardants (for example, melamine sulfate), halogen type flame retardants, and inorganic type flame retardants (for example, antimony trioxide); dispersants such as a phosphate ester type dispersant, a polyoxyalkylene type dispersant, an acetylene type dispersant, a silicone type dispersant, an anionic dispersant, and a cationic dispersant; and stabilizers such as a borate type stabilizer, a titanate type stabilizer, an aluminate type stabilizer, a zirconate type stabilizer, an isocyanate type stabilizer, a carboxylate type stabilizer, and a carboxylic anhydride type stabilizer. These optional nonvolatile components may be used singly or in combination of two or more kinds thereof at any ratio.

The resin composition according to this embodiment may further includes, in addition to the nonvolatile components described above, an optional organic solvent as a volatile component. The organic solvent is preferably those that can dissolve at least part of the nonvolatile components. Illustrative examples of the organic solvent include: ketone type solvents such as acetone, methyl ethyl ketone, methyl isobutyl ketone, and cyclohexanone; ester type solvents such as methyl acetate, ethyl acetate, butyl acetate, isobutyl acetate, isoamyl acetate, methyl propionate, ethyl propionate, and γ-butyrolactone; ether type solvents such as tetrahydropyran, tetrahydrofuran, 1,4-dioxane, diethyl ether, diisopropyl ether, dibutyl ether, and diphenyl ether; alcohol type solvents such as methanol, ethanol, propanol, butanol, and ethyleneglycol; ether ester type solvents such as 2-ethoxyethyl acetate, propyleneglycol monomethyl ether acetate, diethyleneglycol monoethyl ether acetate, ethyldiglycol acetate, γ-butyrolactone, and methyl methoxypropionate; ester alcohol type solvents such as methyl lactate, ethyl lactate, and methyl 2-hydroxyisobutyrate; ether alcohol type solvents such as 2-methoxypropanol, 2-methoxyethanol, 2-ethoxyethanol, propyleneglycol monomethyl ether, and diethyleneglycol monobutyl ether (butyl carbitol); amide type solvents such as N,N-dimethylformamide, N,N-dimethylacetamide, and N-methyl-2-pyrrolidone; sulfoxide type solvents such as dimethyl sulfoxide; nitrile type solvents such as acetonitrile and propionitrile; aliphatic hydrocarbon type solvents such as hexane, cyclopentane, cyclohexane, and methylcyclohexane; and aromatic hydrocarbon type solvents such as benzene, toluene, xylene, ethylbenzene, and trimethylbenzene. These organic solvents may be used singly or in combination of two or more kinds thereof at any ratio.

In one embodiment, the lower the amount of the organic solvent is, the more preferable it is. Specifically, the amount of the organic solvent relative to 100% by mass of the nonvolatile components in the resin composition may be, for example, 3% or less by mass, 1% or less by mass, 0.5% or less by mass, 0.1% or less by mass, or 0.01% or less by mass. In particular, it is especially preferable that the organic solvent be not included in the resin composition (namely, the amount of the organic solvent is 0% by mass). When the amount of the organic solvent is low, generation of voids due to vaporization of the organic solvent can be suppressed. Furthermore, the handling property and workability of the resin composition can be improved.

### [7. Properties of the Resin Composition]

According to the resin composition relating to the embodiment described above, the cured product having a high relative magnetic permeability can be obtained. For example, the resin composition is heated at 180°C for 90 minutes to obtain a cured product. When the relative magnetic permeability of this cured product is measured at room temperature of 23°C and with the measurement frequency of 50 MHz, the relative magnetic permeability is preferably 12.0 or more, more preferably 15.0 or more, and still more preferably 18.0 or more, while especially preferably 20.0 or more. There is no particular restriction in the upper limit of the relative magnetic permeability; so, the relative magnetic permeability may be, for example, 35.0 or less, 30.0 or less, 25.0 or less, or 23.0 or less. The relative magnetic permeability can be measured by the method described in EXAMPLES.

According to the resin composition relating to the embodiment described above, the cured product having an excellent polishing workability can be obtained. Specifically, when the resin composition is thermally cured to obtain a cured product, the polished amount per unit time of the cured product can be increased. Because the cured product has an excellent polishing workability as described above, the polishing time (takt) required to reach a prescribed thickness can be made shorter.

Therefore, according to the resin composition relating to the embodiment described above, the cured product that is excellent in both the relative magnetic permeability and the polishing workability can be obtained. In prior art, in order to obtain a cured product having a high relative magnetic permeability, it has been customary to increase the content of the magnetic filler in the resin composition. However, when the content of the magnetic filler is increased in such a way, the hardness of the cured product increases thereby causing a tendency to lower the polishing workability thereof. Because of these circumstances, in prior art, it has been difficult to realize the cured product that is excellent both in the relative magnetic permeability and the polishing workability; so, in light of such circumstances, the effect of the aforementioned resin composition capable of improving both the relative magnetic permeability and the polishing workability is industrially advantageous.

According to the resin composition relating to the embodiment described above, the cured product having a low magnetic loss can usually be obtained. For example, the resin composition is heated at 180°C for 90 minutes to obtain a cured product. When the magnetic loss of this cured product is measured at room temperature of 23°C and with the measurement frequency of 50 MHz, the magnetic loss thereof is preferably less than 0.10, and more preferably less than 0.08, while still more preferably less than 0.05. The magnetic loss may be measured by the method described in EXAMPLES.

Although a crystalline alloy powder such as an alloy powder including Fe and Ni can usually have high relative magnetic permeability, the crystalline allow powder tends to have large magnetic loss. Therefore, conventionally, it has been difficult to obtain the cured product having a high relative magnetic permeability and yet having a low magnetic loss. In light of these conventional circumstances, the effect of the resin composition capable of improving both the relative magnetic permeability and the magnetic loss is industrially advantageous.

There is no particular restriction in the form of the resin composition. The resin composition may be, for example, in solid form. The resin composition may also be in a flowable pasty form. The pasty resin composition is excellent in filling property into a hole of a substrate. In particular, the resin composition is preferably in the pasty form at 23°C. The viscosity of this pasty resin composition is preferably 20 Pa·s or more, more preferably 25 Pa·s or more, and still more preferably 30 Pa·s or more, while especially preferably 50 Pa·s or more, and is preferably 200 Pa·s or less, and more preferably 180 Pa·s or less, while still more preferably 160 Pa·s or less. The viscosity may be measured by the same method as the measurement method of the viscosity of (C) the low-viscosity thermosetting resin.

By making use of the excellent properties described above, it is preferable that the resin composition be used as a resin composition for production of an inductor. For example, in order to produce a circuit substrate included in an inductor substrate, it is preferable that the resin composition be used as the holefilling resin composition to be filled in the hole of the substrate included in the circuit substrate. For example, the resin composition described above is preferably used to form a cured product layer in the circuit substrate. In order to help application of the resin composition to these uses, the resin composition may be used as the pasty form or as a resin sheet form that includes the layer of the resin composition.

### [8. Production Method of the Resin Composition]

The resin composition according to this embodiment may be produced, for example, by mixing the components to be included into the resin composition with an arbitrary preparation vessel. The components to be included in the resin composition may be mixed in an arbitrary order; alternatively, part or the whole of the components may be mixed simultaneously. In the course of mixing of each component, the temperature may be set as appropriate. For example, temporarily or throughout the entire process, heating and/or cooling may be carried out. In the course of mixing of each component, stirring or shaking may be carried out. At the time of mixing or thereafter, the resin composition may be uniformly dispersed by stirring or shaking with a stirring machine such as a mixer or with a shaking machine. At the same time as stirring or shaking, defoaming may be carried out under a reduced pressure condition such as a vacuum condition.

### [9. Resin Sheet]

The resin sheet includes a support and a resin composition layer formed on the support, the resin composition layer being formed of the resin composition.

In view of thinning, thickness of the resin composition layer is preferably 250 µm or less, and more preferably 200 µm or less. Although the lower limit of the thickness of the resin composition layer is not particularly restricted, for example, it may be 5 µm or more, or 10 µm or more.

Illustrative examples of the support include a film formed of a plastic material, metal foil, and a releasing paper. Among them, a film formed of a plastic material and metal foil are preferable.

When the film formed of a plastic material is used as the support, illustrative examples of the plastic material include polyesters such as polyethylene terephthalate (hereinafter, this may be simply called "PET") and polyethylene naphthalate (hereinafter, this may be simply called "PEN"); polycarbonate (hereinafter, this may be simply called "PC"); acrylic polymers such as polymethyl methacrylate (PMMA); a cyclic polyolefin; triacetyl cellulose (TAC); polyether sulfide (PES); polyether ketone; and polyimide. Among them, polyethylene terephthalate and polyethylene naphthalate are preferable, while inexpensive polyethylene terephthalate is especially preferable.

When the metal foil is used as the support, illustrative examples of the metal foil include copper foil and aluminum foil, while copper foil is preferable. As the copper foil, the foil formed of a copper single metal or an alloy of copper with other metal (for example, tin, chromium, silver, magnesium, nickel, zirconium, silicon, and titanium) may be used.

The support may be subjected to a treatment such as a mat treatment, or a corona treatment on the surface to be bonded with the resin composition layer.

As for the support, the releasing layer-attached support having the releasing layer on the surface to be bonded with the resin composition layer may be used. The releasing agent to be used for the releasing layer of the releasing layer-attached support is, for example, one or more releasing agents selected from the group consisting of an alkyd type releasing agent, a polyolefin type releasing agent, a urethane type releasing agent, and a silicone type releasing agent. Commercially available products may be used as the leasing layer-attached support; they are, for example, a PET film having the releasing layer formed of mainly a silicone type releasing agent or an alkyd resin type releasing agent. Illustrative examples thereof include: "PET501010", "SK-1", "AL-5", and "AL-7", which are all manufactured by Lintec Corp.; "Lumirror T60" manufactured by Toray Industries; "Purex" manufactured by Teijin Ltd.; and "Unipeel" manufactured by Unitika Ltd.

Although thickness of the support is not particularly restricted, this is preferably in the range of 5 µm to 75 µm, while more preferably in the range of 10 µm to 60 µm. When the releasing layer-attached support is used, total thickness of the releasing layer-attached support is preferably within this range.

In the resin sheet, a protection film similar to the support can be further laminated on the surface of the resin composition layer not bonded to the support (namely, on the surface opposite to the support). Although thickness of the protection film is not particularly restricted, for example, this is in the range of 1 µm to 40 µm. By laminating the protection film, the surface of the resin composition layer can be prevented from attachment of dirt and the like as well as from a scar. The resin sheet can be rolled up so as to be stored. When the resin sheet has the protection film, the resin sheet can be used by removing the protection film.

The resin sheet may be produced, for example, by applying the resin composition on the support by means of a die coater or the like to form the resin composition layer. As needed, the resin composition is mixed with an organic solvent; and then, this may be applied onto the support. When the organic solvent is used, as needed, drying may be carried out after the application.

Drying may be carried out by heating, blowing with a hot air, or the like. The drying condition is not particularly restricted. The drying is carried out under the drying condition so as to bring the content of the organic solvent in the resin composition layer to usually 10% or less by mass, while preferably 5% or less by mass. The resin composition layer may be formed by drying in the temperature range of 50 °C to 150°C for 3 minutes to 10 minutes, although the condition is different depending on the components included in the resin composition.

The resin sheet can be rolled up so as to be stored. When the resin sheet has the protection film, the resin sheet can be used by removing the protection film.

### [10. Circuit Substrate]

The circuit substrate according to one embodiment of the present invention includes the cured product of the aforementioned resin composition. Specific structure of the circuit substrate is not particularly restricted so far as the cured product of the resin composition is included therein. The circuit substrate relating to a first example includes a substrate in which a through hole is formed and a cured product of the resin composition filled in the through hole. The circuit substrate relating to a second example includes a cured product layer formed of the cured product of the resin composition. Hereinafter, the production methods of the circuit substrates relating to the first example and the second example will be explained.

### [10.1. Circuit Substrate Relating to the First Example]

The circuit substrate relating to the first example includes the substrate in which a hole is formed and the cured product of the resin composition that is filled in the hole. This circuit substrate may be produced, for example, by the method including:
(1) a step of filling the resin composition into the hole of the substrate, and
(2) a step of thermally curing the resin composition to obtain the cured product thereof. The production method of the circuit substrate relating to the first example may further include:
(3) a step of polishing the surface of the cured product,
(4) a step of subjecting the cured product to roughening treatment, and
(5) a step of forming a conductive layer on the roughened surface of the cured product. The steps (1) to (5) are usually carried out in the order of (1) to (5). In the production method of the circuit substrate relating to the first example, it is preferable that the cured product be formed by using the pasty resin composition. The explanation thereinafter will be made as to the example of the substrate formed with a through hole as the hole that penetrates through the substrate in the thickness direction.

### <Step (1)>

The step (1) usually includes a step of preparing a substrate in which a through hole is formed. The substrate may be prepared by purchasing from the market. Alternatively, the substrate may be prepared by production using a suitable material. Hereinafter, the production method of the substrate relating to one example will be explained.

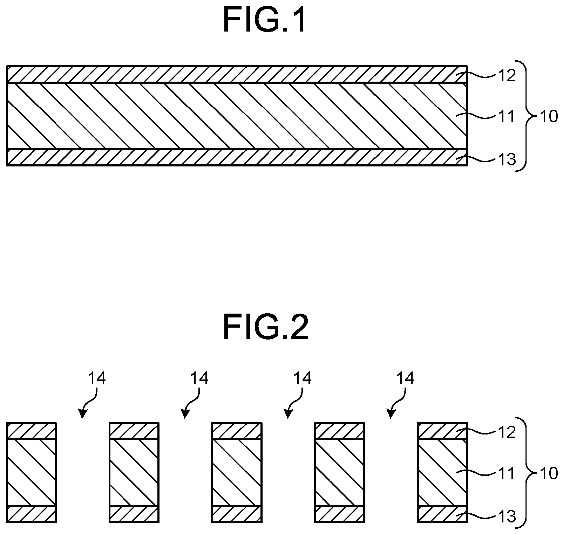

Fig. 1 is a schematic sectional view illustrating the core substrate 10 that is prepared in the production method of the circuit substrate relating to the first example according to one embodiment of the present invention. The step of preparing the substrate may include the step of preparing the core substrate 10 as illustrated in Fig. 1 as one example. The core substrate 10 usually includes a supporting substrate 11. Illustrative examples of the supporting substrate 11 include insulating substrates such as a glass epoxy substrate, a metal substrate, a polyester substrate, a polyimide substrate, a BT resin substrate, and a thermosetting type polyphenylene ether substrate. On the supporting substrate 11, a metal layer may be formed. The metal layer may be formed on one surface of the supporting substrate 11, or on both the surfaces thereof. Here, the example is illustrated in which a first metal layer 12 and a second metal layer 13 are formed on both the surfaces of the supporting substrate 11. The first metal layer 12 and the second metal layer 13 may be the layers formed of a metal such as copper. The first metal layer 12 and the second metal layer 13 may be, for example, copper foil such as the carrier-attached copper foil, or a metal layer formed of the material of the conducive layer that is going to be described later.

Fig. 2 is a schematic sectional view illustrating the core substrate 10 in which a through hole 14 is formed in the production method of the circuit substrate relating to the first example according to one embodiment of the present invention. As illustrated in Fig. 2 as one example, the step of preparing the substrate may include a step of forming the through hole 14 in the core substrate 10. The through hole 14 may be formed, for example, by drilling, laser irradiation, or plasma irradiation. The through hole 14 can usually be formed by forming a penetrating hole through the core substrate 10. Specifically, formation of the through hole 14 can be carried out by using a drilling machine that is commercially available. Illustrative examples of the commercially available drilling machine include "ND-1S211" manufactured by Hitachi Via Mechanics, Ltd.

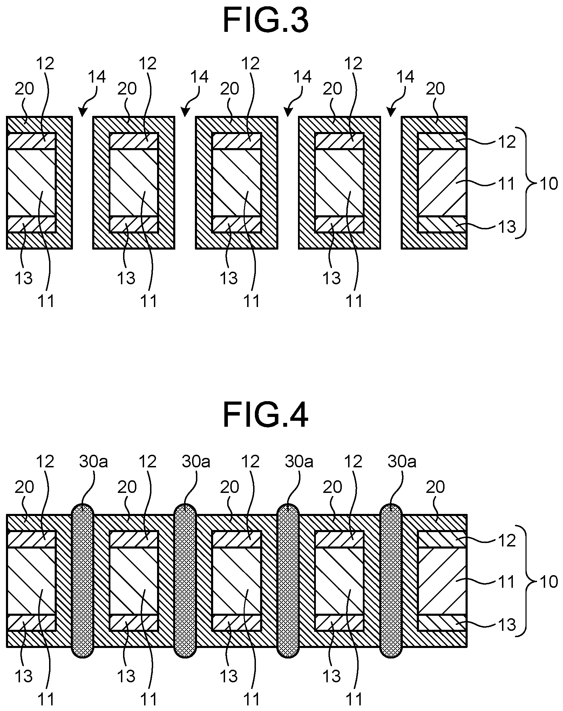

Fig. 3 is a schematic sectional view illustrating the core substrate 10 formed with a plated layer 20 in the through hole 14 in the production method of the circuit substrate relating to the first example according to one embodiment of the present invention. After the core substrate 10 is subjected to roughening treatment as needed, the step of preparing the substrate may include the step of forming a plated layer 20, as illustrated in Fig. 3. The roughening treatment may be carried out with any of a dry roughening treatment and a wet roughening treatment. Plasma treatment may be one example of the dry roughening treatment. An example of the wet roughening treatment may be the method in which a swelling treatment by a swelling liquid, a roughening treatment by an oxidant, and a neutralizing treatment by a neutralizing liquid are carried out in this order. The plated layer 20 may be formed by a plating method. The procedure to form the plated layer 20 by the plating method may be the same as that in formation of the conductive layer at the step (5) that is going be described later. Here, the explanation will be made as to the example in which the plated layer 20 is formed inside the through hole 14, on the surface of the first metal layer 12, and on the surface of the second metal layer 13.

Fig. 4 is a schematic sectional view illustrating the state of a resin composition 30a filled in the through hole of the core substrate 10 in the production method of the circuit substrate relating to the first example according to one embodiment of the present invention. As illustrated in Fig. 4, the step (1) includes filling the resin composition 30a into the through hole 14 of the core substrate 10 after the core substrate 10 in which the through hole 14 is formed is prepared as mentioned before. The filling may be carried out, for example, by a printing method. Illustrative examples of the printing method include a method in which the resin composition 30a is printed into the through hole 14 with a squeegee, a method in which the resin composition 30a is printed via a cartridge, a method in which the resin composition 30a is printed by a mask printing, a roll coating method, and an inkjet method. An excess of the resin composition 30a is usually protruded on or attached to the outside of the through hole 14. Therefore, the resin composition 30a may be formed not only inside the through hole 14 but also outside the through hole 14.

### <Step (2)>

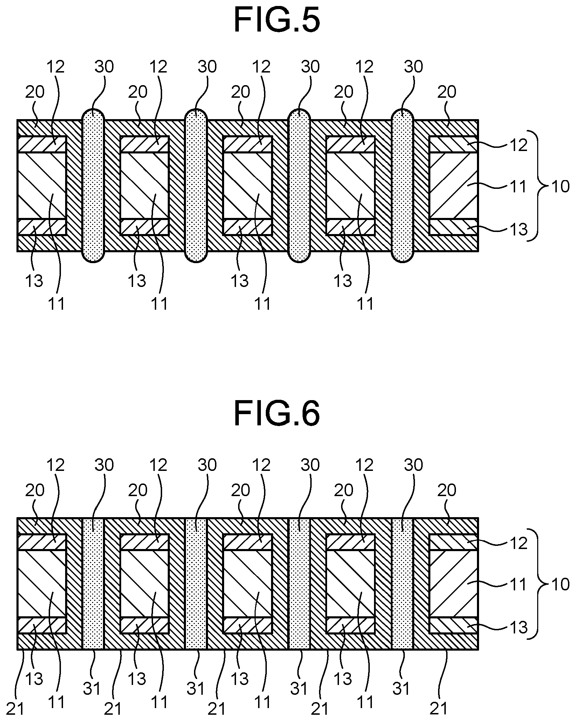

Fig. 5 is a schematic sectional view to explain the step (2) in the production method of the circuit substrate relating to the first example according to one embodiment of the present invention. The step (2) includes curing the resin composition 30a to form a cured product 30 after the resin composition 30a is filled into the through hole 14, as illustrated in Fig. 5.

Curing of the resin composition 30a is usually carried out by thermal curing. The thermal curing condition of the resin composition 30a may be set as appropriate so far as curing of the resin composition 30a can be proceeded. The curing temperature is preferably 120°C or higher, and more preferably 130°C or higher, while still more preferably 150°C or higher, and is preferably 245°C or lower, and more preferably 220°C or lower, while still more preferably 200°C or lower. The curing period is preferably 5 minutes or longer, and more preferably 10 minutes or longer, while still more preferably 15 minutes or longer, and preferably 120 minutes or shorter, and more preferably 110 minutes or shorter, while still more preferably 100 minutes or shorter.

The curing degree of the cured product 30 that is obtained at the step (2) is preferably 80% or more, and more preferably 85% or more, while still more preferably 90% or more. The curing degree may be measured by using, for example, a differential scanning calorimeter.

The production method of the circuit substrate relating to the first example may include, after the resin composition 30a is filled in the through hole 14 and before the resin composition 30a is cured, a step of heating the resin composition 30a at the temperature lower than the curing temperature thereof (preliminary heating step). For example, before curing the resin composition 30a, the resin composition 30a may be pre-heated usually at 50°C or higher and lower than 120°C (preferably 60°C or higher and 110°C or lower, while more preferably 70°C or higher and 100°C or lower) with the period of usually 5 minutes or longer (preferably 5 minutes or longer and 150 minutes or shorter, while more preferably 15 minutes or longer and 120 minutes or shorter).

### <Step (3)>

Fig. 6 is a schematic sectional view to explain the step (3) in the production method of the circuit substrate relating to the first example according to one embodiment of the present invention. The step (3) includes, after the cured product 30 is obtained by curing the resin composition 30a, polishing an excess of the cured product 30 that is protruded on or attached to the core substrate 10, as illustrated in Fig. 6. Because the excess of the cured product 30 can be removed by polishing, the surface of the cured product 30 can be flattened. A surface (polished surface) 31 of the cured product 30 that has been flattened by polishing can usually form a flat surface that is flush with a surface 21 (for example, the surface of the core substrate 10 and the surface of the plated layer 20) around the polished surface 31. Because the cured product 30 of the resin composition according to the embodiment described above is excellent in the polishing workability, the cured product can be polished promptly without problems.

As for the polishing method of the cured product 30, a method with which an excess of the cured product 30 that is protruded on or attached to the core substrate 10 can be removed may be used. Illustrative examples of such a polishing method include a buff polishing method, a belt polishing method, and a ceramic polishing method. Illustrative examples of the buff polishing equipment that is commercially available include "NT-700IM" manufactured by Ishiihyoki Co., Ltd.

From a viewpoint to enhance the adhesion with the conductive layer, the arithmetic average roughness (Ra) of the polished surface 31 of the cured product 30 is preferably 300 nm or more, and more preferably 350 nm or more, while still more preferably 400 nm or more. The upper limit thereof is preferably 1,000 nm or less, and more preferably 900 nm or less, while still more preferably 800 nm or less. The surface roughness (Ra) can be measured by using, for example, a non-contact type surface roughness meter.

In order to further increase the curing degree of the cured product 30, the production method of the circuit substrate relating to the first example may include, after the step (3), a step of subjecting the cured product 30 to heating treatment. The temperature at the heating treatment may correspond to the curing temperature described before. Specifically, the heating-treatment temperature is preferably 120°C or higher, and more preferably 130°C or higher, while still more preferably 150°C or higher, and is preferably 245°C or lower, and more preferably 220°C or lower, while still more preferably 200°C or lower. The heating-treatment period is preferably 5 minutes or longer, and more preferably 10 minutes or longer, while still more preferably 15 minutes or longer, and is preferably 90 minutes or shorter, and more preferably 70 minutes or shorter, while still more preferably 60 minutes or shorter.

### <Step (4)>

The step (4) includes subjecting the polished surface 31 of the cured product 30 to roughening treatment (desmearing treatment). The procedure and condition of the roughening treatment are not particularly restricted; for example, the procedure and condition that are used in the production method of a multilayer printed wiring board may be used. Specifically, the cured product 30 may be subjected to the roughening treatment, for example, by carrying out a swelling treatment with a swelling liquid, a roughening treatment with an oxidant, and a neutralizing treatment with a neutralizing liquid in this order.

Illustrative examples of the swelling liquid that may be used in the roughening process include an alkaline solution, and a surfactant solution. The alkaline solution is preferable. As for the alkaline solution as the swelling liquid, a sodium hydroxide solution and a potassium hydroxide solution are more preferable. Illustrative examples of the swelling liquid that is commercially available include "Swelling Dip Securiganth P" and "Swelling Dip Securiganth SBU", which are manufactured by Atotech Japan Co., Ltd.

The swelling treatment with the swelling liquid can be carried out, for example, by soaking the cured product 30 into the swelling liquid in the temperature range of 30°C to 90°C and for the period of 1 minutes to 20 minutes. From a viewpoint to suppress swelling of the resins that are included in the cured product 30 to a suitable level, it is preferable that the cured product 30 be soaked into the swelling liquid in the temperature range of 40°C to 80°C and for the period of 5 minutes to 15 minutes.

As for the oxidant that can be used in the roughening treatment by the oxidant, illustrative examples thereof include an alkaline permanganate solution having potassium permanganate or sodium permanganate dissolved into a sodium hydroxide aqueous solution. The roughening treatment using the oxidant such as the alkaline permanganate solution may be carried out preferably by soaking the cured product 30 into the oxidant solution heated at 60°C to 80°C for the period of 10 minutes to 30 minutes. Concentration of the permanganate salt in the alkaline permanganate solution is preferably 5% by mass to 10% by mass. Illustrative examples of the oxidant that is commercially available include alkaline permanganate solutions such as "Concentrate Compact P" and "Dosing Solution Securiganth P", which are manufactured by Atotech Japan, Co., Ltd.

The neutralizing liquid that can be used in the neutralizing treatment is preferably an acidic aqueous solution. Illustrative examples of commercially available products of the neutralizing liquid include "Reduction Solution Securiganth P", which is manufactured by Atotech Japan Co., Ltd. Neutralizing treatment with the neutralizing liquid can be carried out by soaking the treated surface having been treated with the roughening treatment using the oxidant solution into the neutralizing liquid in the temperature range of 30°C to 80°C for the period of 5 minutes to 30 minutes. From a viewpoint of workability and the like, it is preferable to soak the cured product 30, which has been treated with the roughening treatment using the oxidant solution, into the neutralizing liquid in the temperature range of 40°C to 70°C for the period of 5 minutes to 20 minutes.

From a viewpoint to enhance the adhesion with the conductive layer, the arithmetic average roughness (Ra) of the surface of the cured product 30 after the roughening treatment is preferably 300 nm or more, and more preferably 350 nm or more, while still more preferably 400 nm or more. The upper limit thereof is preferably 1,500 nm or less, and more preferably 1,200 nm or less, while still more preferably 1,000 nm or less. The surface roughness (Ra) can be measured by using, for example, a non-contact type surface roughness meter.

### <Step (5)>

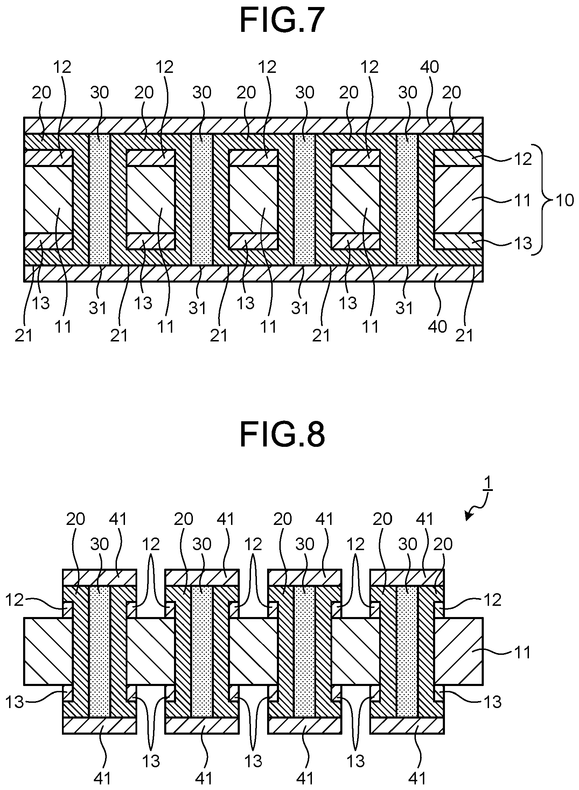

Fig. 7 is a schematic sectional view to explain the step (5) in the production method of the circuit substrate relating to the first example according to one embodiment of the present invention. The step (5) includes forming a conductive layer 40 on the polished surface 31 of the cured product 30, as illustrated in Fig. 7. Here, the example is illustrated in which the conductive layer 40 is formed not only on the polished surface 31 of the cured product 30 but also on the surface 21 therearound (for example, the surface of the core substrate 10 and the surface of the plated layer 20). In Fig. 7, the example that the conductive layer 40 is formed on both sides of the core substrate 10 is illustrated; but the conductive layer 40 may be formed on one side of the core substrate 10.

Fig. 8 is a schematic sectional view to explain the step (5) in the production method of the circuit substrate relating to the first example according to one embodiment of the present invention. The step (5) may include, after the conductive layer 40 is formed, removing part of the conductive layer 40, the first metal layer 12, the second metal layer 13, and the plated layer 20 by etching or the like to form a patterned conductive layer 41, as illustrated in Fig. 8.

Illustrative examples of the method for forming the conductive layer 40 include a plating method, a sputtering method, and a vapor deposition method. Among these, the plating method is preferable. In a preferable embodiment, the surface of the cured product 30 (and the plated layer 20) is plated with a suitable method such as a semi-additive method or a full additive method, so that the patterned conductive layer 41 having an intended wiring pattern may be formed. Illustrative examples of the material of the conductive layer 40 include single metals such as gold, platinum, palladium, silver, copper, aluminum, cobalt, chromium, zinc, nickel, titanium, tungsten, iron, tin, and indium; and metal alloys of two or more metals selected from the group consisting of gold, platinum, palladium, silver, copper, aluminum, cobalt, chromium, zinc, nickel, titanium, tungsten, iron, tin, and indium. Among these, from viewpoints of general applicability, cost, easiness in patterning, and the like, preferably usable are chromium, nickel, titanium, aluminum, zinc, gold, palladium, silver, and copper, as well as a nickel-chromium alloy, a copper-nickel alloy, and a copper-titanium alloy. More preferable are chromium, nickel, titanium, aluminum, zinc, gold, palladium, silver, and copper, as well as a nickel-chromium alloy. Copper is still more preferably used.

Here, an example of the method to form the patterned conductive layer 41 on the polished surface 31 of the cured product 30 will be explained in detail. A plated seed layer is formed on the polished surface 31 of the cured product 30 by electroless plating. Next, onto the plated seed layer thus formed, an electroplated layer is formed by electroplating. Then, as needed, an unnecessary plated seed layer is removed by a process such as etching, so that the patterned conductive layer 41 having an intended wiring pattern can be formed. After the patterned conductive layer 41 is formed, with an aim to enhance the adhesion strength of the patterned conductive layer 41, an annealing treatment may be carried out, as needed. The annealing treatment may be carried out, for example, by heating in the temperature range of 150 to 200°C for the period of 20 to 90 minutes.

From a viewpoint of thinning, the thickness of the patterned conductive layer 41 is preferably 70 µm or less, more preferably 60 µm or less, still more preferably 50 µm or less, and far still more preferably 40 µm or less, while especially preferably 30 µm or less, 20 µm or less, 15 µm or less, or 10 µm or less. The lower limit thereof is preferably 1 µm or more, and more preferably 3 µm or more, while still more preferably 5 µm or more.

With the method described above, a circuit substrate 1 including the cured product 30 of the resin composition 30a can be produced.

### [10.2. Circuit Substrate Relating to Second Example]

The circuit substrate relating to the second example includes a cured product layer formed of a cured product of the resin composition. It is preferable that this cured product layer be formed by using a resin sheet. This circuit substrate may be produced by, for example, the production method including:
(i) a step of laminating a resin sheet onto an inner layer substrate in such a way that a resin composition layer can be adhered with the inner layer substrate and forming a cured product layer;
(ii) a step of forming a hole in the curd product layer;
(iii) a step of roughening a surface of the cured product layer; and
(iv) a step of forming a conductive layer on the surface of the cured product layer.

### <Step (i)>

The step (i) includes laminating a resin sheet onto an inner layer substrate in such a way that a resin composition layer can be adhered with the inner layer substrate and forming a cured product layer. For example, the resin sheet is laminated onto the inner layer substrate in such a way that the resin composition layer can be adhered with the inner layer substrate, and then, the resin composition layer is thermally cured to form a cured product layer.

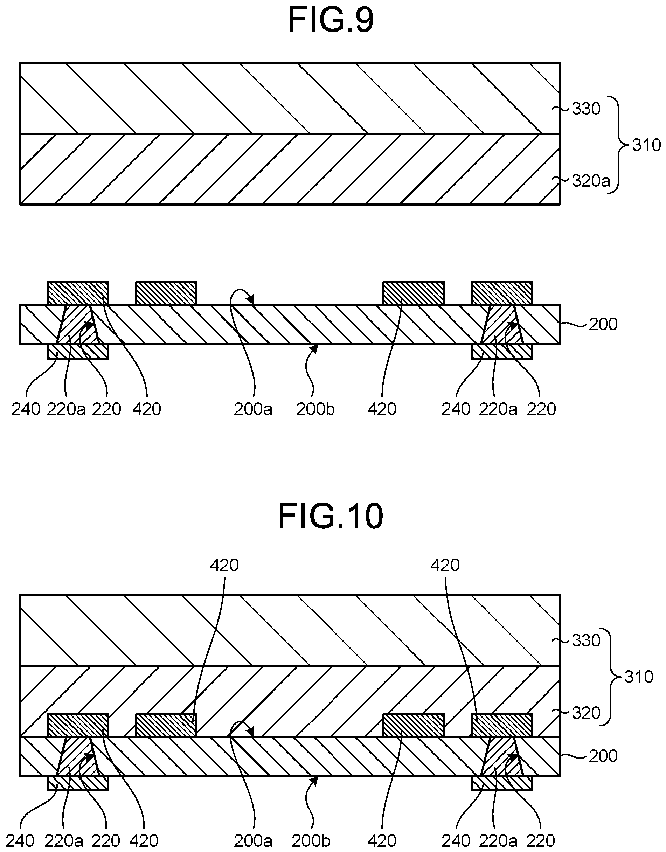

Fig. 9 is a schematic sectional view to explain the step (i) in the production method of the circuit substrate relating to the second example according to one embodiment of the present invention. As illustrate in Fig. 9, a resin sheet 310 that includes a support 330 and a resin composition layer 320a formed on the support 330 is prepared. Then, the resin sheet 310 is laminated onto an inner layer substrate 200 in such a way that the resin composition layer 320a can be adhered with the inner layer substrate 200.

The inner layer substrate 200 may be an insulating substrate. Illustrative examples of the inner layer substrate 200 include insulating substrates such as a glass epoxy substrate, a metal substrate, a polyester substrate, a polyimide substrate, a BT resin substrate, and a thermosetting type polyphenylene ether substrate. The inner layer substrate 200 may be an inner circuit substrate having a wiring or the like incorporated in the thickness thereof.

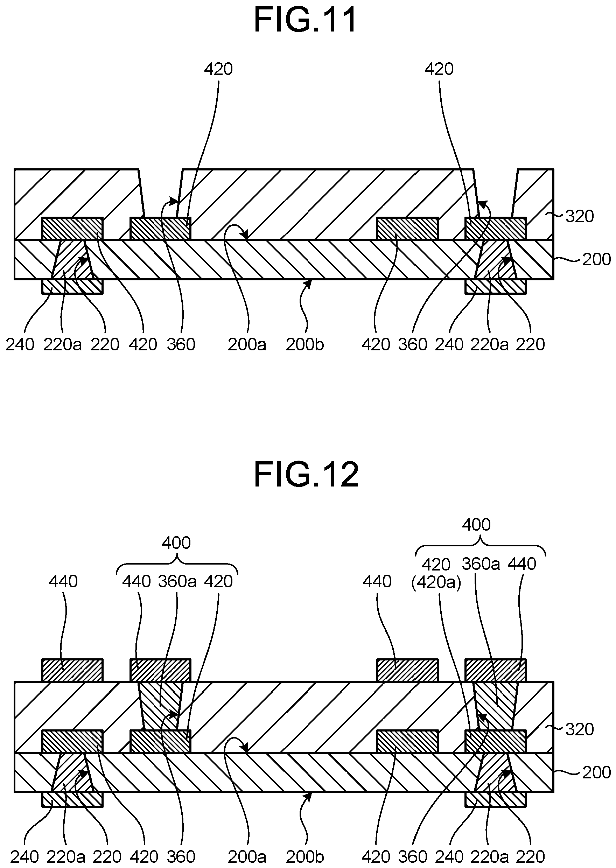

The inner layer substrate 200 in this example includes a first conductive layer 420 formed on a first main surface 200a and an outside terminal 240 formed on a second main surface 200b. The first conductive layer 420 may include a plurality of wirings. Note that in the example illustrated by Fig. 9, only a wiring that constitutes a coil-like conductive structural body 400 (see Fig. 12) of an inductor element is illustrated. The outside terminal 240 may be a terminal to electrically connect to an outside device or the like that is not illustrated in the drawing. The outside terminal 240 may be constructed as part of the conductive layer formed on the second main surface 200b.

Conductive materials that may construct the first conductive layer 420 and the outside terminal 240 are, for example, the same as the materials of the conductive layer that have been explained in the first example.

The first conductive layer 420 and the outside terminal 240 may have any of a monolayer structure or a multilayer structure in which two or more layers formed of single metal layers or alloy layers formed of different metals are laminated. Thicknesses of the first conductive layer 420 and of the outside terminal 240 may be the same as those of a second conductive layer 440 that is going to be described later.

The line (L)/space (S) ratio of the first conductive layer 420 and the outside terminal 240 is not particularly restricted. From a viewpoint to reduce irregularity of the surface thereby obtaining the cured product layer that is excellent in the smoothness, the ratio is usually 900/900 µm or less, preferably 700/700 µm or less, more preferably 500/500 µm or less, and still more preferably 300/300 µm or less, while far still more preferably 200/200 µm or less. The lower limit of the line/space ratio is not particularly restricted; from a viewpoint to enhance an embedding property of the resin composition layer into the space, the ratio is preferably 1/1 µm or more.

The inner layer substrate 200 may have a plurality of through holes 220 that are formed so as to penetrate through the inner layer substrate 200 from the first main surface 200a to the second main surface 200b. In the through hole 220, an in-the-through-hole wiring 220a is formed. The in-the-through-hole wiring 220a electrically connects the first conductive layer 420 with the outside terminal 240.

Adhesion of the resin composition layer 320a with the inner layer substrate 200 can be carried out, for example, by hot-press adhesion of the resin sheet 310 to the inner layer substrate 200 by pressing from the side of the support 330. Illustrative examples of the component for hot-press adhesion of the resin sheet 310 to the inner layer substrate 200 (hereinafter, this component is also called "hot-pressing component") include a heated metal plate (such as stainless steel (SUS) mirror plate) and a heated metal roll (SUS roll). Here, it is preferable that the hot-pressing component be not pressed in direct contact with the resin sheet 310 but be pressed via a sheet or the like formed of an elastic material such as a heat-resistant rubber so that the resin sheet 310 may well follow the surface irregularity of the inner layer substrate 200.

The temperature at the time of the hot-press adhesion is preferably in the range of 80°C to 160°C, and more preferably in the range of 90°C to 140°C, while still more preferably in the range of 100°C to 120°C. The pressure at the time of the hot-press adhesion is preferably in the range of 0.098 MPa to 1.77 MPa, while more preferably in the range of 0.29 MPa to 1.47 MPa. The period at the time of the hot-press adhesion is preferably in the range of 20 seconds to 400 seconds, while more preferably in the range of 30 seconds to 300 seconds. The adhesion of the resin sheet with the inner layer substrate is carried out preferably under an evacuated condition with the pressure of 26.7 hPa or less.

Adhesion of the resin composition layer 320a of the resin sheet 310 with the inner layer substrate 200 can be carried out by using a commercially available vacuum laminator. Illustrative examples of the commercially available vacuum laminator include a vacuum press type laminator manufactured by Meiki Co., Ltd. and a vacuum applicator manufactured by Nikko-Materials Co., Ltd.

After adhesion of the resin sheet 310 with the inner layer substrate 200, for example, the laminated resin sheet 310 may be flattened by pressing with the hot-pressing component from the side of the support 330 under a normal pressure (under an atmospheric pressure). The pressing conditions at the flattening process may be the same as the hot-press adhering condition in the beforementioned lamination. The flattening process may be carried out by using a commercially available laminator. The lamination and the flattening processes may be carried out continuously by using the commercially available vacuum laminator described above.

Fig. 10 is a schematic sectional view to explain the step (i) in the production method of the circuit substrate relating to the second example according to one embodiment of the present invention. After the resin sheet 310 is laminated onto the inner layer substrate 200, the resin composition layer 320a is cured to form a cured product layer. In this example, as illustrated in Fig. 10, the resin composition layer 320a that is adhered with the inner layer substrate 200 is thermally cured to form a first cured product layer 320.

Conditions of the thermal curing of the resin composition layer 320a may be set as appropriate so far as curing of the resin composition can be proceeded. The curing temperature is preferably 120°C or higher, and more preferably 130°C or higher, while still more preferably 150°C or higher, and is preferably 245°C or lower, and more preferably 220°C or lower, while still more preferably 200°C or lower. The curing period is preferably 5 minutes or longer, and more preferably 10 minutes or longer, while still more preferably 15 minutes or longer, and is preferably 120 minutes or shorter, and more preferably 110 minutes or shorter, while still more preferably 100 minutes or shorter.

The support 330 may be removed between after the thermal curing at the step (i) and the step (ii), or after the step (ii).

From a viewpoint to enhance the adhesion with the plated layer, the arithmetic average roughness (Ra) of the cured product layer before the roughening treatment is preferably 300 nm or more, and more preferably 350 nm or more, while still more preferably 400 nm or more. The upper limit thereof is preferably 1,000 nm or less, and more preferably 900 nm or less, while still more preferably 800 nm or less. The surface roughness (Ra) can be measured by using, for example, a non-contact type surface roughness meter.

At the step (i), the cured product layer may be formed by applying the resin composition, in place of the resin sheet, onto the inner layer substrate 200 by using a die coater or the like, which is then followed by thermal curing thereof.

### <Step (ii)>

Fig. 11 is a schematic sectional view to explain the step (ii) in the production method of the circuit substrate relating to the second example according to one embodiment of the present invention. The step (ii), as illustrated in Fig. 11, includes forming a hole in the first cured product layer 320 to form a via hole 360. The via hole 360 will be a channel to electrically connect a first conductive layer 420 with a second conductive layer 440 that is going to be described later. Formation of the via hole 360 may be carried out by using a drill, a laser, a plasma, or the like. The size and shape of the hole may be arbitrarily determined in accordance with a design of the printed wiring board as appropriate.

### <Step (iii)>

At the step (iii), the surface of the cured product layer formed with the via hole is roughened. The roughening treatment at the step (iii) may be carried out with the same method as explained in the step (4) of the first example.

From a viewpoint to enhance the adhesion with a plating, the arithmetic average roughness (Ra) of the cured product layer after the roughening treatment is preferably 300 nm or more, and more preferably 350 nm or more, while still more preferably 400 nm or more. The upper limit thereof is preferably 1,500 nm or less, and more preferably 1,200 nm or less, while still more preferably 1,000 nm or less. The surface roughness (Ra) may be measured, for example, by using a non-contact type surface roughness meter.

### <Step (iv)>

Fig. 12 is a schematic sectional view to explain the step (iv) in the production method of the circuit substrate relating to the second example according to one embodiment of the present invention. As illustrated in Fig. 12, at the step (iv), the second conductive layer 440 is formed on the first cured product layer 320.

The conductive materials capable of constructing the second conductive layer 440 may be the same as those of the conductive layer explained in the first example.

From a viewpoint of thinning, the thickness of the second conductive layer 440 is preferably 70 µm or less, more preferably 60 µm or less, still more preferably 50 µm or less, and far still more preferably 40 µm or less, while especially preferably 30 µm or less, 20 µm or less, 15 µm or less, or 10 µm or less. The lower limit thereof is preferably 1 µm or more, and more preferably 3 µm or more, while still more preferably 5 µm or more.

The second conductive layer 440 can be formed by plating. For example, the second conductive layer 440 is preferably formed by a wet plating method such as a semi-additive method including an electroless plating process, a mask patterning process, an electroplating process, and a flash etching process, as well as a full additive method. When the second conductive layer 440 is formed by the wet plating method, the second conductive layer 440 having an intended wiring pattern can be formed. Note that, at this step, an inside-the-via-hole wiring 360a is concurrently formed in the via hole 360.

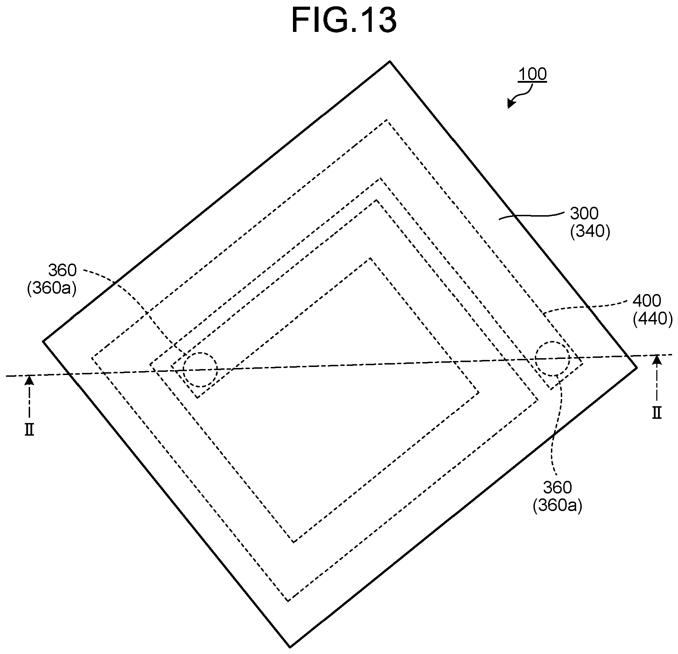

The first conductive layer 420 and the second conductive layer 440 may be formed, for example, spirally, as illustrated in Fig. 13 to Fig. 15 to be described later as one example. In one example, one end in the center side of the spiral wiring portion of the second conductive layer 440 is electrically connected through the inside-the-via-hole wiring 360a to one end in the center side of the spiral wiring portion of the first conductive layer 420. Other end in the circumferential side of the spiral wiring portion of the second conductive layer 440 is electrically connected through the inside-the-via-hole wiring 360a to a land 420a of the first conductive layer 420. Therefore, the other end in the circumferential side of the spiral wiring portion of the second conductive layer 440 is electrically connected to the outside terminal 240 through the inside-the-via-hole wiring 360a, the land 420a, and the inside-the-through-hole wiring 220a.

The coil-like conductive structural body 400 is composed of the spiral wiring portion that is part of the first conductive layer 420, the spiral wiring portion that is part of the second conductive layer 440, and the inside-the-via-hole wiring 360a that electrically connects between the spiral wiring portion of the first conductive layer 420 and the spiral wiring portion of the second conductive layer 440.

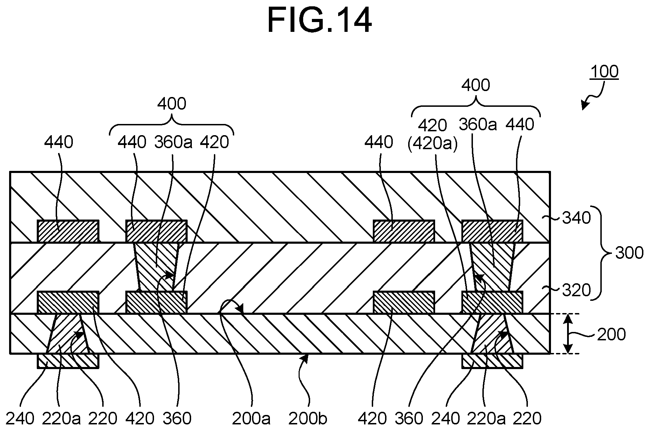

After the step (iv), a step of further forming a cured product layer on the conductive layer may be carried out. Specifically, as illustrated in Fig. 14 as one example, a second cured product layer 340 is formed on the first cured product layer 320 formed with the second conductive layer 440 and an in-the-via-hole wiring 360a. The second cured product layer may be formed with the same step as the step that has already been explained. With the method described above, a circuit substrate 100 that includes the first cured product layer 320 and the second cured product layer 340 formed of the cured product of the resin composition can be produced.

### [11. Inductor Substrate]

The inductor substrate includes the circuit substrate described above. When the inductor substrate includes the circuit substrate that is obtained by the production method of the circuit substrate relating to the first example as described above, this may have an inductor pattern that is formed by a conductor around at least part of the cured product of the resin composition. In this case, the inductor substrate may include an inductor element that is composed of the inductor pattern, which is formed, for example, by at least part of the first metal layer 12, the second metal layer 13, the plated layer 20, and the patterned conductive layer 41, and a core part that is formed of the cured product 30 that is surrounded by this inductor pattern. As such an inductor substrate, the one described in, for example, Japanese Patent Application Laid-open No. 2016-197624 is applicable.

When the inductor substrate includes the circuit substrate that is obtained by the production method of the circuit substrate relating to the second example, this may have the cured product layer and a conductive structural body having at least part thereof embedded into the cured product layer. Then, the inductor substrate may include the inductor element that is composed of this conductive structural body and part of the cured product layer that is extendedly present in a thickness direction of the cured product layer and surrounded with the conductive structural body.

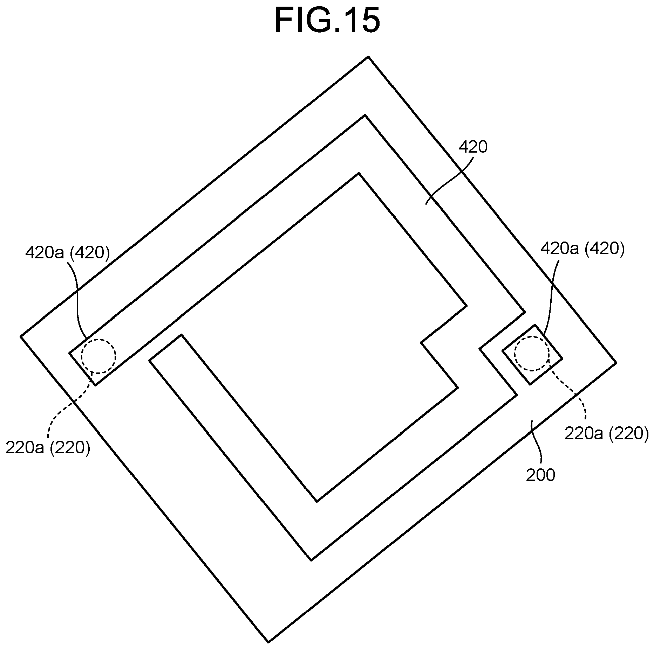

Fig. 13 is a schematic plane view of the circuit substrate 100 possessed by the inductor substrate, observed from one side in the thickness direction thereof. Fig. 14 is a schematic view illustrating a cut edge face of the circuit substrate 100 that is cut at the place indicated by the II-II one dot chain line in Fig. 13. Fig. 15 is a schematic plane view to explain the composition of the first conductive layer 420 of the circuit substrate 100 included in the inductor substrate.

As illustrated in Fig. 13 and Fig. 14 as one example, a circuit substrate 100 has a plurality of the cured product layers (the first cured product layer 320 and the second cured product layer 340) and a plurality of the conductive layers (the first conductive layer 420 and the second conductive layer 440). Namely, this circuit substrate 100 can be a build-up wiring board having build-up cured product layers and build-up conductive layers. The circuit substrate 100 has an inner substrate 200.

As illustrated in Fig. 14, the first cured product layer 320 and the second cured product layer 340 constitute a magnetic member 300, which can be regarded as an integrated cured product layer. Therefore, the coil-like conductive structural body 400 is formed in such a way that at least part thereof is imbedded into the magnetic member 300. Namely, in the circuit substrate 100 according to this example, the inductor element is composed of the coil-like conductive structural body 400 and a core part, which is extendedly present in the thickness direction of the magnetic member 300 and is part of the magnetic member 300 that is surrounded with the coil-like conductive structural body 400.

As illustrated in Fig. 15 as one example, the first conductive layer 420 includes the spiral wiring portion to constitute the coil-like conductive structure 400 and the land 420a in a square shape that is electrically connected to the inside-the-through-hole wiring 220a. According to this example, the spiral wiring portion includes a linear portion, a bent portion that is bent at a right angle, and a detour portion that detours the land 420a. Outline of the entire spiral wiring portion of the first conductive layer 420 is substantially in a square shape and has a shape that the wiring portion is whirled in the anticlockwise direction from a center side to an outer side.

Similarly, the second conductive layer 440 is formed on the first cured product layer 320. The second conductive layer 440 includes the spiral wiring portion to constitute the coil-like conductive structural body 400. In Fig. 13 or Fig. 14, the spiral wiring portion includes a linear portion and a bent portion that is bent at a right angle. In Fig. 13 or Fig. 14, outline of the entire spiral wiring portion of the second conductive layer 440 is substantially in a square shape and has a shape that the wiring portion is whirled in the clockwise direction from a center side to an outer side.

The inductor substrate described above can be used as the wiring board to mount an electronic part such as a semiconductor chip, and can also be used as a (multilayered) printed wiring board that uses this wiring board as the inner substrate. In addition, this can be used as a chip inductor part obtained by dicing the wiring board, and can also be used as a printed wiring board that is surfacemounted with the chip inductor part.

In addition, by using this wiring board, semiconductor devices with various embodiments can be produced. The semiconductor device having the wiring board can be suitably used in electric products (for example, a computer, a mobile phone, a digital camera, and a television), vehicles (for example, a motor bike, an automobile, a train, a marine ship, and an airplane), and so forth.

### EXAMPLES

Hereinafter, the present invention will be specifically explained by Examples. Note that the present invention is not limited to the Examples described hereinafter. In the description below, "part" and "%" that describe quantities mean "part by mass" and "% by mass", respectively, unless otherwise specifically mentioned. The temperature condition and the pressure condition are at room temperature (25°C) and an atmospheric pressure (1 atm), respectively, unless otherwise specified as to the temperature.

### [Example 1]

150 parts by mass of the Fe-Ni alloy powder a1 (alloy of Fe 49.75%, Ni 49.75%, and B 0.5%; volume-average particle diameter of 3 µm; manufactured by DOWA Electronics Materials Co., Ltd.), 1 part by mass of the liquid epoxy resin a ("630"; a glycidylamine type epoxy resin, epoxy equivalent of 95 g/eq., manufactured by Mitsubishi Chemical Corp.), 3 parts by mass of the liquid epoxy resin b ("ZX-1059"; a mixture of a bisphenol A type epoxy resin and a bisphenol F type epoxy resin; viscosity of 2,000 mPa·s at 23°C, manufactured by Nippon Steel Chemical & Materials Co., Ltd.), 3 parts by mass of the liquid epoxy resin c ("EP-4088S"; a glycidyl ether type aliphatic epoxy resin; viscosity at 23°C is 230 mPa·s, manufactured by ADEKA Corp.), and 1 part by mass of the curing facilitator ("2MZA-PW"; imidazole type curing facilitator; manufactured by Shikoku Chemicals Corp.) were mixed and uniformly dispersed with a high-speed rotation mixer to obtain the pasty resin composition 1. From the specific gravity, the amount of the Fe-Ni alloy powder a1 was calculated to be 70% by volume relative to 100% by volume of the nonvolatile components in the resin composition 1.

### [Example 2]

The pasty resin composition 2 was produced with the same way as Example 1 except that 150 parts by mass of the Fe-Ni alloy powder a2 (alloy of Fe 49.75%, Ni 49.75%, and Si 0.5%; volume-average particle diameter of 3 µm; manufactured by DOWA Electronics Materials Co., Ltd.) was used in place of the Fe-Ni alloy powder a1. From the specific gravity, the amount of the Fe-Ni alloy powder a2 was calculated to be 70% by volume relative to 100% by volume of the nonvolatile components in the resin composition 2.

### [Example 3]

The pasty resin composition 3 was produced with the same way as Example 1 except that 150 parts by mass of the Fe-Ni alloy powder a3 (alloy of Fe 49.75%, Ni 49.75%, and P 0.5%; volume-average particle diameter of 3 µm; manufactured by DOWA Electronics Materials Co., Ltd.) was used in place of the Fe-Ni alloy powder a1. From the specific gravity, the amount of the Fe-Ni alloy powder a3 was calculated to be 70% by volume relative to 100% by volume of the nonvolatile components in the resin composition 3.

### [Example 4]

The pasty resin composition 4 was produced with the same way as Example 1 except that 150 parts by mass of the Fe-Ni alloy powder a4 (alloy of Fe 39.75%, Ni 59.75%, and B 0.5%; volume-average particle diameter of 3 µm; manufactured by DOWA Electronics Materials Co., Ltd.) was used in place of the Fe-Ni alloy powder a1. From the specific gravity, the amount of the Fe-Ni alloy powder a4 was calculated to be 70% by volume relative to 100% by volume of the nonvolatile components in the resin composition 4.

### [Example 5]

The pasty resin composition 5 was produced with the same way as Example 1 except that 150 parts by mass of the Fe-Ni alloy powder a5 (alloy of Fe 59.75%, Ni 39.75%, and B 0.5%; volume-average particle diameter of 3 µm; manufactured by DOWA Electronics Materials Co., Ltd.) was used in place of the Fe-Ni alloy powder a1. From the specific gravity, the amount of the Fe-Ni alloy powder a5 was calculated to be 70% by volume relative to 100% by volume of the nonvolatile components in the resin composition 5.

### [Example 6]

The pasty resin composition 6 was produced with the same way as Example 1 except that the amount of the Fe-Ni alloy powder a1 was changed from 150 parts by mass to 100 parts by mass. From the specific gravity, the amount of the Fe-Ni alloy powder a1 was calculated to be 61% by volume relative to 100% by volume of the nonvolatile components in the resin composition 6.

### [Example 7]

The pasty resin composition 7 was produced with the same way as Example 1 except that the amount of the Fe-Ni alloy powder a1 was changed from 150 parts by mass to 190 parts by mass. From the specific gravity, the amount of the Fe-Ni alloy powder a1 was calculated to be 75% by volume relative to 100% by volume of the nonvolatile components in the resin composition 7.

### [Example 8]

The pasty resin composition 8 was produced with the same way as Example 1 except that 150 parts by mass of the Fe-Ni alloy powder a6 (alloy of Fe 49.95%, Ni 49.95%, and B 0.1%; volume-average particle diameter of 3 µm; manufactured by DOWA Electronics Materials Co., Ltd.) was used in place of the Fe-Ni alloy powder a1. From the specific gravity, the amount of the Fe-Ni alloy powder a6 was calculated to be 70% by volume relative to 100% by volume of the nonvolatile components in the resin composition 8.

### [Example 9]

The pasty resin composition 9 was produced with the same way as Example 1 except that 150 parts by mass of the Fe-Ni alloy powder a7 (alloy of Fe 45%, Ni 45%, and B 10%; volume-average particle diameter of 3 µm; manufactured by DOWA Electronics Materials Co., Ltd.) was used in place of the Fe-Ni alloy powder a1. From the specific gravity, the amount of the Fe-Ni alloy powder a7 was calculated to be 70% by volume relative to 100% by volume of the nonvolatile components in the resin composition 9.

### [Example 10]

The pasty resin composition 10 was produced with the same way as Example 1 except that the amount of the liquid epoxy resin a was changed from 1 part by mass to 4.5 parts by mass, that the amount of the liquid epoxy resin b was changed from 3 parts by mass to 1.5 parts by mass, and that the amount of the liquid epoxy resin c was changed from 3 parts by mass to 1 part by mass. From the specific gravity, the amount of the Fe-Ni alloy powder a1 was calculated to be 70% by volume relative to 100% by volume of the nonvolatile components in the resin composition 10.

### [Example 11]

The pasty resin composition 11 was produced with the same way as Example 1 except that the amount of the liquid epoxy resin a was changed from 1 part by mass to 0.4 part by mass, that the amount of the liquid epoxy resin b was changed from 3 parts by mass to 3.3 parts by mass, and that the amount of the liquid epoxy resin c was changed from 3 parts by mass to 3.3 parts by mass. From the specific gravity, the amount of the Fe-Ni alloy powder a1 was calculated to be 70% by volume relative to 100% by volume of the nonvolatile components in the resin composition 11.

### [Example 12]

The pasty resin composition 12 was produced with the same way as Example 1 except that 150 parts by mass of the Fe-Ni alloy powder a8 (alloy of Fe 49.75%, Ni 49.75%, and B 0.5%; volume-average particle diameter of 5.5 µm; manufactured by DOWA Electronics Materials Co., Ltd.) was used in place of the Fe-Ni alloy powder a1. From the specific gravity, the amount of the Fe-Ni alloy powder a8 was calculated to be 70% by volume relative to 100% by volume of the nonvolatile components in the resin composition 12.

### [Comparative Example 1]

The pasty resin composition 13 was produced with the same way as Example 1 except that 150 parts by mass of the Fe-Ni alloy powder a9 (alloy of Fe 50% and Ni 50%; volume-average particle diameter of 3 µm; manufactured by DOWA Electronics Materials Co., Ltd.) was used in place of the Fe-Ni alloy powder a1. From the specific gravity, the amount of the Fe-Ni alloy powder a9 was calculated to be 70% by volume relative to 100% by volume of the nonvolatile components in the resin composition 13.

### [Comparative Example 2]

The pasty resin composition 14 was produced with the same way as Example 1 except that 150 parts by mass of the Fe-Ni alloy powder a10 (alloy of Fe 35% and Ni 65%; volume-average particle diameter of 3 µm; manufactured by DOWA Electronics Materials Co., Ltd.) was used in place of the Fe-Ni alloy powder a1. From the specific gravity, the amount of the Fe-Ni alloy powder a10 was calculated to be 70% by volume relative to 100% by volume of the nonvolatile components in the resin composition 14.

### [Comparative Example 3]

The pasty resin composition 15 was produced with the same way as Example 1 except that 150 parts by mass of the Fe-Ni alloy powder a11 (alloy of Fe 20% and Ni 80%; volume-average particle diameter of 3 µm; manufactured by DOWA Electronics Materials Co., Ltd.) was used in place of the Fe-Ni alloy powder a1. From the specific gravity, the amount of the Fe-Ni alloy powder a11 was calculated to be 70% by volume relative to 100% by volume of the nonvolatile components in the resin composition 15.

### [Comparative Example 4]

The pasty resin composition 16 was produced with the same way as Example 1 except that 150 parts by mass of the Fe-Ni alloy powder a12 (alloy of Fe 65% and Ni 35%; volume-average particle diameter of 3 µm; manufactured by DOWA Electronics Materials Co., Ltd.) was used in place of the Fe-Ni alloy powder a1. From the specific gravity, the amount of the Fe-Ni alloy powder a12 was calculated to be 70% by volume relative to 100% by volume of the nonvolatile components in the resin composition 16.

### [Comparative Example 5]

The pasty resin composition 17 was produced with the same way as Example 1 except that the liquid epoxy resin a was not used, and that the amount of the liquid epoxy resin b was changed from 3 parts by mass to 4 parts by mass. From the specific gravity, the amount of the Fe-Ni alloy powder a1 was calculated to be 70% by volume relative to 100% by volume of the nonvolatile components in the resin composition 17.

### [Measurement of Viscosity]

The viscosity was measured by using an E-type viscometer ("RE-80U"; 3°x R9.7 rotor, manufactured by Toki Sangyo Co., Ltd.) with keeping the sample temperature at 23°C, and with the sample amount of 0.22 mL and the measurement condition with the rotation number of 5 rpm.

### [Measurements of Relative Magnetic Permeability and Magnetic Loss]

A polyethylene terephthalate (PET) film treated with a silicone type releasing agent was prepared as the support ("PET 501010"; thickness of 50 µm; manufactured by Lintec Corp.). Each of the resin compositions produced in Examples and Comparative Examples was uniformly applied onto the release-treated surface of the PET film by using a doctor blade in such a way that the thickness of the resin composition layer after drying was 100 µm to obtain a magnetic sheet. The magnetic sheet thus obtained was heated at 180°C for 90 minutes to thermally cure the resin composition layer. Then, the support was removed to obtain a cured product in a sheet form. The cured product thus obtained was cut to a toroidal type specimen having the outer diameter of 19 mm and the inner diameter of 9 mm to obtain an evaluation sample. The relative magnetic permeability (µ') and the imaginary part (µ") of this evaluation sample were measured by using a measurement instrument ("16454A E4991B"; manufactured by Keysight Technologies, Inc.) at room temperature of 23°C with the measurement frequency of 50 MHz. The magnetic loss was calculated from µ"/µ'.

The relative magnetic permeability was evaluated in accordance with the following standard.
"Good": The relative magnetic permeability is 12 or more.
"Not" Good: The relative magnetic permeability is less than 12.

The magnetic loss was evaluated in accordance with the following standard.
"Good": The magnetic loss is less than 0.1.
"Not" Good: The magnetic loss is 0.1 or more.

### [Evaluation of Polishing Workability]

### - Preparation of Substrate for Evaluation -

A both-surface copper clad epoxy-impregnated glass cloth substrate ("R1515A"; manufactured by Panasonic Corp.; thickness of the copper foil: 18 µm, thickness of the substrate: 0.8 mm) that had cupper foils on surfaces thereof was prepared as the support. All the copper foil on the surfaces of the support was removed by etching, followed by drying at 190°C for 30 minutes. Each of the resin compositions produced in Examples and Comparative Examples was uniformly applied onto the support by using a doctor blade in such a way that the thickness of the resin composition layer after drying was 200 µm to obtain a magnetic sheet. The magnetic sheet thus obtained was heated at 190°C for 90 minutes to thermally cure the resin composition layer, and the cured product having a sheet form was obtained.

### - Evaluation of Polishing Workability -

The surface of the cured product was buff-polished by using a polishing machine ("NT-700IM"; manufactured by Ishiihyoki Co., Ltd.) under a constant condition for a constant period. The thickness of the cured product after polishing was measured with a film thickness measurement instrument; then, this was evaluated in accordance with the following standard. It is indicated that the thinner the cured product is, the better the polishing workability is.
"A": Thickness after polishing is less than 100 µm.
"B": Thickness after polishing is 100 µm or more and less than 150 µm.
"C": Thickness after polishing is 150 µm or more.

### [Results]

The results of Examples and Comparative Examples are summarized in Table 1 and Table 2 below. In these tables, D50 represents the volume-average particle diameter.

**[Table 1. Results of Examples 1 to 9]**

| | | | Example | | | | | | | | |
|---|---|---|---|---|---|---|---|---|---|---|---|
| | | | 1 | 2 | 3 | 4 | 5 | 6 | 7 | 8 | 9 |
| component (A) | composition of alloy | D50 | | | | | | | | | |
| a1 | Fe49.75Ni49.75B0.5 | 3µm | 150 | | | | | 100 | 190 | | |
| a2 | Fe49.75Ni49.75Si0.5 | 3µm | | 150 | | | | | | | |
| a3 | Fe49.75Ni49.75P0.5 | 3µm | | | 150 | | | | | | |
| a4 | Fe39.75Ni59.75B0.5 | 3µm | | | | 150 | | | | | |
| a5 | Fe59.75Ni39.75B0.5 | 3µm | | | | | 150 | | | | |
| a6 | Fe49.95Ni49.95B0.1 | 3µm | | | | | | | | 150 | |
| a7 | Fe45Ni45B10 | 3µm | | | | | | | | | 150 |
| a8 | Fe49.75Ni49.75B0.5 | 5.5µm | | | | | | | | | |
| a9 | Fe50Ni50 | 3µm | | | | | | | | | |
| a10 | Fe35Ni65 | 3µm | | | | | | | | | |
| a11 | Fe20Ni80 | 3µm | | | | | | | | | |
| a12 | Fe65Ni35 | 3µm | | | | | | | | | |
| component (B) | | | | | | | | | | | |
| liquid epoxy resin a | | | 1 | 1 | 1 | 1 | 1 | 1 | 1 | 1 | 1 |
| component (C) | | | | | | | | | | | |
| liquid epoxy resin b | | | 3 | 3 | 3 | 3 | 3 | 3 | 3 | 3 | 3 |
| liquid eposy resin c | | | 3 | 3 | 3 | 3 | 3 | 3 | 3 | 3 | 3 |
| component (D) | | | | | | | | | | | |
| curing agent | | | 1 | 1 | 1 | 1 | 1 | 1 | 1 | 1 | 1 |
| M(b)/M(c) | | | 0.17 | 0.17 | 0.17 | 0.17 | 0.17 | 0.17 | 0.17 | 0.17 | 0.17 |
| viscosity | | Pa·s | 155 | 145 | 162 | 150 | 147 | 120 | 195 | 167 | 165 |
| relative magnetic permeability (50MHz) | | value | 21.0 | 19.0 | 19.2 | 22.0 | 15.3 | 12.5 | 29.0 | 23.0 | 15.0 |
| | | evaluation | good | good | good | good | good | good | good | good | good |
| magnetic loss (50MHz) | | value | 0.04 | 0.06 | 0.09 | 0.09 | 0.02 | 0.04 | 0.07 | 0.07 | 0.02 |
| | | evaluation | good | good | good | good | good | good | good | good | good |
| polishing workability | | | A | A | A | A | A | A | A | A | A |

**[Table 2. Results of Examples 10 to 12 and Comparative Examples 1 to 4]**

| | | | Example | | | Comparative Example | | | | |
|---|---|---|---|---|---|---|---|---|---|---|
| | | | 10 | 11 | 12 | 1 | 2 | 3 | 4 | 5 |
| component (A) | composition of alloy | D50 | | | | | | | | |
| a1 | Fe49.75Ni49.75B0.5 | 3µm | 150 | 150 | | | | | | 150 |
| a2 | Fe49.75Ni49.75Si0.5 | 3µm | | | | | | | | |
| a3 | Fe49.75Ni49.75P0.5 | 3µm | | | | | | | | |
| a4 | Fe39.75Ni59.75B0.5 | 3µm | | | | | | | | |
| a5 | Fe59.75Ni39.75B0.5 | 3µm | | | | | | | | |
| a6 | Fe49.95Ni49.95B0.1 | 3µm | | | | | | | | |
| a7 | Fe45Ni45B 10 | 3µm | | | | | | | | |
| a8 | Fe49.75Ni49.75B0.5 | 5.5µm | | | 150 | | | | | |
| a9 | Fe50Ni50 | 3µm | | | | 150 | | | | |
| a10 | Fe35Ni65 | 3µm | | | | | 150 | | | |
| a11 | Fe20Ni80 | 3µm | | | | | | 150 | | |
| a12 | Fe65Ni35 | 3µm | | | | | | | 150 | |
| component (B) | | | | | | | | | | |
| liquid epoxy resin a | | | 4.5 | 0.4 | 1 | 1 | 1 | 1 | 1 | |
| composition (C) | | | | | | | | | | |
| liquid epoxy resin b | | | 1.5 | 3.3 | 3 | 3 | 3 | 3 | 3 | 4 |
| liquid epoxy resin c | | | 1 | 3.3 | 3 | 3 | 3 | 3 | 3 | 3 |
| composition (D) | | | | | | | | | | |
| curing agent | | | 1 | 1 | 1 | 1 | 1 | 1 | 1 | 1 |
| M(b)/M(c) | | | 1.80 | 0.06 | 0.17 | 0.17 | 0.17 | 0.17 | 0.17 | - |
| viscosity | | Pa·s | 172 | 140 | 153 | 160 | 154 | 171 | 168 | 156 |
| relative magnetic permeability (50MHz) | | value | 29.0 | 29.0 | 23.0 | 13.5 | 13.8 | 14.2 | 9.0 | 21.0 |
| | | evaluation | good | good | good | good | good | good | not good | good |
| magnetic loss (50MHz) | | value | 0.07 | 0.07 | 0.15 | 0.12 | 0.15 | 0.18 | 0.02 | 0.04 |
| | | evaluation | good | good | not good | not good | not good | not good | good | good |
| polishing workability | | | A | A | A | B | C | C | C | C |

### [Reference Example 1]

When the X-ray diffraction spectrum of the Fe-Ni alloy powder is measured, a strong peak is generally observed in the plane indices (0,0,2). Therefore, from the peak width (integral width) that is observed in the range of 2θ=50.5 to 52.0 °, distortion of the crystal structure can be evaluated. Thus, in order to confirm that the crystal structure of the Fe-Ni alloy was distorted by the additive element, the following experiment was carried out. In the following experiment, the full width at half maximum of the peak was used as the integral width of the peak.

The X-ray diffraction spectrum of the Fe-Ni alloy powder a1 including the additive element was measured. Here, the integral width w1 of the peak appeared in the range of 2θ=50.5 to 52.0 ° was measured.

The X-ray diffraction spectrum of the Fe-Ni alloy powder a9 not including the additive element was measured. Here, the integral width w9 of the peak appeared in the range of 2θ=50.5 to 52.0 ° was measured.

The integral width ratio w1/w9 was calculated to be 1.28, indicating that the integral width of the Fe-Ni alloy powder a1 was wider than the integral width of the Fe-Ni alloy powder a9. From this result, it was confirmed that the crystal structure of the Fe-Ni alloy powder was distorted because of the additive element in this alloy. The inventors of the present invention presume that the effects described above are obtained by, as one cause, this distortion of the crystal structure.

### Explanation of references

- 1: circuit substrate
- 10: core substrate
- 11: supporting substrate
- 12: first metal layer
- 13: second metal layer
- 14: through hole
- 20: plated layer
- 21: surface around a polished surface
- 30: cured product
- 30a: resin composition
- 31: polished surface of a cured product (polished surface)
- 40: conductive layer
- 41: patterned conductive layer
- 100: circuit substrate
- 200: inner layer substrate
- 200a: first main surface
- 200b: second main surface
- 220: through hole
- 220a: in-the-through-hole wiring
- 240: outside terminal
- 310: resin sheet
- 320: first cured product layer
- 320a: resin composition layer
- 330: support
- 360: via hole
- 360a: inside-the-via-hole wiring
- 400: coil-like conductive structural body
- 420: first conductive layer
- 420a: land
- 440: second conductive layer

## Claims

1. A resin composition comprising:
(A) a Fe-Ni alloy powder; and
(B) an epoxy resin containing one or more nitrogen atoms in a molecular skeleton thereof, wherein the component (A) contains one or more elements selected from the group consisting of B, P, and Si,
when a mass of the component (A) and a mass of the component (B), relative to 100% by mass of the nonvolatile components included in the resin composition, are designated by M(a) and M(b), respectively, a ratio M(b)/M(a) is 0.001 or more and 0.100 or less, **characterised in that**
an amount of one or more elements selected from the group consisting of B, P and Si included in the component (A) is 0.40% or more by mass and 6.00% or less by mass, relative to 100% by mass of (A).

2. The resin composition according to claim 1, wherein a total amount of Fe and Ni included in the component (A) is 94.00% or more by mass and 99.60% or less by mass.

3. The resin composition according to claim 1 or claim 2, wherein a volume-average particle diameter of the component (A) is less than 6.0 µm.

4. The resin composition according to any one of claims 1 to 3, wherein an amount of the component (A) relative to 100% by volume of nonvolatile components included in the resin composition is 60% or more by volume and 85% or less by volume.

5. The resin composition according to any one of claims 1 to 4, further comprising (C) a thermosetting resin whose viscosity at 23°C is 5 mPa·s or more and 5000 mPa·s or less.

6. The resin composition according to claim 5, wherein when a mass of the component (B) and a mass of the component (C), relative to 100% by mass of the nonvolatile components included in the resin composition, are designated by M(b) and M(c), respectively, a ratio M(b)/M(c) is 0.05 or more and 2.50 or less.

7. The resin composition according to any one of claims 1 to 6, further comprising (D) a curing agent.

8. The resin composition according to any one of claims 1 to 7, wherein the component (A) contains 0.90% or less by mass of one or more elements selected from the group consisting of B, P, and Si.

9. The resin composition according to any one of claims 1 to 8, wherein the resin composition is in a pasty form at 23°C.

10. The resin composition according to any one of claims 1 to 9, wherein component (A) contains boron.

11. The resin composition according to any one of claims 1 to 10, wherein component (A) contains phosphorus.

12. Use of a resin composition according to any one of claims 1 to 11 to fill a hole.

13. A cured product of a resin composition, **characterized in that** the resin composition is according to any one of claims 1 to 11.

14. A circuit substrate **characterized in that** it comprises a cured product of the resin composition according to any one of claims 1 to 11.

15. An inductor substrate **characterized in that** it comprises the circuit substrate according to claim 14.

## Patentansprüche

1. Harzzusammensetzung, die Folgendes umfasst:
(A) ein Fe-Ni-Legierungspulver; und
(B) ein Epoxidharz, das ein oder mehrere Stickstoffatome in einem molekularen Gerüst daraus enthält,
wobei die Komponente (A) ein oder mehrere Elemente enthält, die aus der aus B, P und Si bestehenden Gruppe ausgewählt sind,
wenn die Masse von Komponente (A) und die Masse von Komponente (B) bezogen auf 100 Masse-% der nichtflüchtigen Komponenten, die in der Harzzusammensetzung enthalten sind, als M(a) bzw. M(b) bezeichnet werden, das Verhältnis M(b)/M(a) 0,001 oder mehr und 0,100 oder weniger beträgt,
**dadurch gekennzeichnet, dass** die Menge eines oder mehrerer in Komponente (A) enthaltenen Elemente, die aus der aus B, P und Si bestehenden Gruppe ausgewählt sind, bezogen auf 100 Masse-% von (A) 0,40 Masse-% oder mehr und 6,00 Masse-% oder weniger beträgt.

2. Harzzusammensetzung nach Anspruch 1, wobei die in Komponente (A) enthaltene Gesamtmenge an Fe und Ni 94,00 Masse-% oder mehr und 99,60 Masse-% oder weniger beträgt.

3. Harzzusammensetzung nach Anspruch 1 oder Anspruch 2, wobei der volumenmittlere Teilchendurchmesser von Komponente (A) weniger als 6,0 µm beträgt.

4. Harzzusammensetzung nach einem der Ansprüche 1 bis 3, wobei die Menge von Komponente (A) bezogen auf 100 Vol.-% der nichtflüchtigen Komponenten, die in der Harzzusammensetzung enthalten sind, 60 Vol.-% oder mehr und 85 Vol.-% oder weniger beträgt.

5. Harzzusammensetzung nach einem der Ansprüche 1 bis 4, die weiters (C) ein duroplastisches Harz umfasst, dessen Viskosität bei 23 °C 5 mPa·s oder mehr und 5.000 mPa·s oder weniger beträgt.

6. Harzzusammensetzung nach Anspruch 5, wobei, wenn die Masse von Komponente (B) und die Masse von Komponente (C) bezogen auf 100 Masse-% der nichtflüchtigen Komponenten, die in der Harzzusammensetzung enthalten sind, als M(b) bzw. M(c) bezeichnet werden, das Verhältnis M(b)/M(c) 0,05 oder mehr und 2,50 oder weniger beträgt.

7. Harzzusammensetzung nach einem der Ansprüche 1 bis 6, die weiters (D) einen Härter umfasst.

8. Harzzusammensetzung nach einem der Ansprüche 1 bis 7, wobei Komponente (A) 0,90 Masse-% oder weniger von einem oder mehreren Elementen enthält, die aus der aus B, P und Si bestehenden Gruppe ausgewählt sind.

9. Harzzusammensetzung nach einem der Ansprüche 1 bis 8, wobei die Harzzusammensetzung bei 23 °C in pastöser Form vorliegt.

10. Harzzusammensetzung nach einem der Ansprüche 1 bis 9, wobei Komponente (A) Bor enthält.

11. Harzzusammensetzung nach einem der Ansprüche 1 bis 10, wobei Komponente (A) Phosphor enthält.

12. Verwendung einer Harzzusammensetzung nach einem der Ansprüche 1 bis 11 zum Füllen eines Lochs.

13. Gehärtetes Produkt aus einer Harzzusammensetzung, **dadurch gekennzeichnet, dass** die Harzzusammensetzung eine nach einem der Ansprüche 1 bis 11 ist.

14. Schaltkreissubstrat, **dadurch gekennzeichnet, dass** es ein gehärtetes Produkt aus einer Harzzusammensetzung nach einem der Ansprüche 1 bis 11 umfasst.

15. Induktorsubstrat, **dadurch gekennzeichnet, dass** es ein Schaltkreissubstrat nach Anspruch 14 umfasst.

## Revendications

1. Composition de résine, comprenant :
(A) une poudre d'alliage Fe-Ni ; et
(B) une résine époxy contenant un ou plusieurs atomes d'azote dans un squelette moléculaire de celle-ci,
dans laquelle le composant (A) contient un ou plusieurs éléments choisis dans le groupe constitué de B, P et Si,
lorsqu'une masse du composant (A) et une masse du composant (B), par rapport à 100 % en masse des composants non volatils inclus dans la composition de résine, sont désignées respectivement par M(a) et M(b), un rapport M(b)/M(a) est supérieur ou égal à 0,001 et inférieur ou égal à 0,100, **caractérisée en ce que**
une quantité des un ou plusieurs éléments choisis dans le groupe constitué de B et de P inclus dans le composant (A) est de 0,40 % en masse ou plus et de 6,00 % en masse ou moins, par rapport à 100 % en masse de (A).

2. Composition de résine selon la revendication 1, dans laquelle une quantité totale de Fe et de Ni incluse dans le composant (A) est de 94,00 % en masse ou plus et de 99,60 % en masse ou moins.

3. Composition de résine selon la revendication 1, dans laquelle un diamètre de particule moyen en volume du composant (A) est inférieur à 6,0 µm.

4. Composition de résine selon la revendication 1 à la revendication 3, dans laquelle une quantité du composant (A) par rapport à 100 % en volume de composants non volatils inclus dans la composition de résine est de 60 % en volume ou plus et de 85 % en volume ou moins.

5. Composition de résine selon l'une quelconque des revendications 1 à 3, comprenant en outre (C) une résine thermodurcissable dont la viscosité à 23°C est de 5 mPa·s ou plus et de 5 000 mPa·s ou moins.

6. Composition de résine selon la revendication 5, dans laquelle, lorsqu'une masse du composant (B) et une masse du composant (C), par rapport à 100 % en masse des composants non volatils inclus dans la composition de résine, sont désignées respectivement par M(b) et M(c), un rapport M(b)/M(c) est supérieur ou égal à 0,05 et inférieur ou égal à 2,50.

7. Composition de résine selon l'une quelconque des revendications 1 à 6, comprenant en outre (D) un agent de durcissement.

8. Composition de résine selon l'une quelconque des revendications 1 à 7, dans laquelle le composant (A) contient 0,010 en masse ou plus et 0,90 % en masse ou moins d'un ou plusieurs éléments choisis dans le groupe constitué de B, P et Si.

9. Composition de résine selon l'une quelconque des revendications 1 à 8, dans laquelle la composition de résine est sous forme de pâte à 23°C.

10. Composition de résine selon l'une quelconque des revendications 1 à 9, dans laquelle le composant (A) contient du bore.

11. Composition de résine selon l'une quelconque des revendications 1 à 10, dans laquelle le composant (A) contient du phosphore.

12. Utilisation d'une composition de résine selon l'une quelconque des revendications 1 à 11.

13. Produit durci de la composition de résine selon l'une quelconque des revendications 1 à 11.

14. Substrat de circuit comprenant un produit durci de la composition de résine selon l'une quelconque des revendications 1 à 11.

15. Substrat d'inductance comprenant le substrat de circuit selon la revendication 14.
